# EUROPEAN PATENT APPLICATION

(11) **EP 4 684 996 A1**
(43) Date of publication of application: **28.01.2026**
(21) Application number: 24934359.1
(22) Date of filing: 29.08.2024
(51) Int. Cl.: B60K 35/23

(54) **HEAD-UP DISPLAY**

(30) Priority: 30.04.2024 KR 20240057788
(71) Applicant: LG Electronics Inc., Seoul 07336 (KR)
(72) Inventor: KWEON, Ohjin, Seoul 06772 (KR); HAN, Minsu, Seoul 06772 (KR)
(74) Representative: Vossius & Partner Patentanwälte Rechtsanwälte mbB
(86) International application number: PCT/KR2024/012959
(87) International publication number: WO 2025/230051

(57) **Abstract**

The present embodiment comprises a housing having a space formed in the housing; a screen module provided with a tilting shaft and rotatably accommodated in the space; an image generating part that generates image light from outside the space and projects the generated image light onto the screen module; and a tilter that adjusts the tilting angle of the screen module, wherein the screen module is provided with a connector rotatably connected to the tilter.

## Description

### [Technical Field]

The present disclosure relates to a head-up display.

### [Background Art]

A head-up display is a device installed in a vehicle that projects image light toward the windshield of the vehicle. A head-up display for a vehicle can display various information, including driving information, while the vehicle is driving.

A head-up display includes a display panel that generates and outputs image light, and at least one mirror that reflects the image light generated by the display panel.

The image light generated from the display panel can be incident on the vehicle's windshield by a mirror, and the driver can perceive an virtual image at the location in front of the windshield.

Korean Patent Publication No. 10-2467924 B1 (November 17, 2022) discloses a head-up display for a vehicle.

A head-up display for a vehicle includes: a housing having an inner space formed therein and disposed below a windshield; an imaging device accommodated in the inner space and emitting a first linearly polarized light in a first direction; an inner mirror disposed to be spaced apart from the imaging device in the inner space and reflecting the first linearly polarized light in the first direction emitted from the imaging device; a polarizing film transmitting the first linearly polarized light reflected by the inner mirror and reflecting a second linearly polarized light in a second direction orthogonal to the first direction; and a phase retardation mirror disposed outside the inner space and converting the phase of the first linearly polarized light reflected by the inner mirror and then transmitting the polarizing film into a second linearly polarized light and emitting the same to the polarizing film, wherein the second linearly polarized light emitted from the phase retardation mirror is reflected onto the windshield by the polarizing film, and the first linearly polarized light reflected by the inner mirror transmits the polarizing film and then heads toward the windshield.

### [Disclosure]

### [Technical Problem]

The present embodiment provides a head-up display capable of forming a large virtual image while minimizing the size of the housing and having a simple structure with a variable eye box.

### [Technical Solution]

A head-up display according to the present embodiment comprise a housing having a space formed in the housing; a screen module provided with a tilting shaft and rotatably accommodated in the space; an image generating part that generates image light from outside the space and projects the image light onto the screen module; and a tilter that adjusts the tilting angle of the screen module. The screen module may comprise a connector rotatably connected to the tilter.

The screen module may comprise a far region comprising the tilting shaft and a near region comprising the connector.

The image generating part may comprise a concave mirror that expands the image light onto the screen module, and a distance between the outermost edge of the near region and the concave mirror may be shorter than a distance between the outermost edge of the far region and the concave mirror.

The screen module may further comprise a screen; and a screen holder that accommodates the screen, has a connector formed on one end of the screen holder, and a tilting shaft formed on the other end of the screen holder. The screen module may further comprise a screen cover that holds the screen on the screen holder.

The screen module may further comprise a screen cover that holds the screen on the screen holder.

The head-up display may further comprise a bracket fixed to the housing; and a spring disposed between the bracket and the tilting shaft.

The housing may be made of metal.

The tilter may comprise a motor; and a moving bracket connected to the motor and linearly moved, and a connector may be rotatably connected to the moving bracket.

The head-up display may control the motor to vary the position of the eye box.

The position of the eye box may vary depending on the adjustable displacement of the moving bracket.

When the moving bracket is raised above a reference height, the eye box may be lowered, and when the moving bracket is lowered below the reference height, the eye box may be raised.

The moving bracket may comprise an outer bracket connected to a lead screw of the motor; an inner bracket arranged to move along the longitudinal direction of the outer bracket and having a contact end in contact with the connector; and a spring disposed in the outer bracket to elastically support the inner bracket. The moving bracket may be linearly moved by ±3mm.

The moving bracket may be linearly moved by ±3mm.

The tilting angle of the screen module may be within 10°.

The screen module may be tilted by a maximum of 2° or a maximum of -2° relative to a reference plane.

A control board may control the motor to raise or lower the moving bracket to a set height after the moving bracket is positioned at a reference height.

The control board may receive driver information and control the motor based on the information.

The head-up display may further comprise a sensor for detecting the driver's eyes.

The head-up display may further comprise a memory for storing a mode immediately prior to power is turned off, when the power is turned off.

After the power is turned off, when power is reapplied, the control board compares the mode stored in the memory with a mode based on the driver information and controls the motor based on a comparison result.

### [Advantageous Effect]

According to the present embodiment, since the image generating part generates image light outside the housing space, the housing size can be minimized, and the light projected onto the screen module can be reflected onto the windshield, forming a large virtual image.

Furthermore, a tilter connected to the connector of the screen module can adjust the tilt angle of the screen module, allowing the occupant's eye box to be changed with a simple structure.

Furthermore, the screen can be accommodated and protected in the screen holder.

Furthermore, a screen cover can hold the screen on the screen holder, minimizing any movement or separation of the screen.

Furthermore, the tilter comprises a motor and a moving bracket connected to the motor and moving linearly, allowing the screen module to be tilted with a simple structure.

Furthermore, a control board can control the motor to vary the position of the eye box.

Furthermore, the moving bracket comprises an outer bracket, an inner bracket having a contact end that contacts the connector, and a spring that elastically supports the inner bracket, so that the connector can be maintained on the moving bracket and separation between the connector and the moving bracket can be minimized.

Furthermore, the control board receives driver information and controls the motor according to the received information, thereby providing an optimal eye box that matches the driver's eye height, even when the driver changes.

### [Description of Drawings]

FIG. 1 is a view illustrating a head-up display according to the present embodiment when displaying information,
FIG. 2 is a schematic diagram illustrating a head-up display according to the present embodiment,
FIG. 3 is a perspective view schematically illustrating an optical path of an example of a head-up display according to the present embodiment,
FIG. 4 is an exploded perspective view illustrating an example of a head-up display according to the present embodiment,
FIG. 5 is a rear view illustrating the interior of the image generation part of the head-up display illustrated in FIG. 4,
FIG. 6 is a perspective view illustrating an image generation part according to the present embodiment,
FIG. 7 is an exploded perspective view illustrating the illumination optical module according to the present embodiment,
FIG. 8 is a perspective view illustrating an illumination optical module and a housing according to the present embodiment,
FIG. 9 is an exploded perspective view of a projection optical module according to the present embodiment,
FIG. 10 is a perspective view illustrating a light transmitting part formed on a housing or a top cover according to the present embodiment,
FIG. 11 is a perspective view illustrating a light transmitting part of an image generation part according to the present embodiment,
FIG. 12 is a perspective view illustrating a head-up display according to the present embodiment,
FIG. 13 is a side view illustrating a head-up display according to the present embodiment,
FIG. 14 is a perspective view illustrating a screen module according to the present embodiment,
FIG. 15 is an exploded perspective view illustrating a screen module according to the present embodiment,
FIG. 16 is an enlarged view illustrating the tilter according to the present embodiment,
FIG. 17 is a partially cut-away perspective view illustrating a moving bracket according to the present embodiment,
FIG. 18 is a cross-sectional view illustrating a screen according to the present embodiment,
FIG. 19 is a rear view illustrating a screen according to the present embodiment,
FIG. 20 is a cross-sectional view illustrating the Fresnel layer of the screen according to the present embodiment,
FIG. 21 is a perspective view illustrating a modified example of a head-up display according to the present embodiment,
FIG. 22 is a perspective view illustrating the interior of a modified example of a head-up display according to the present embodiment,
FIG. 23 is a schematic diagram illustrating a modified example of a head-up display according to the present embodiment,
FIG. 24 is a control block diagram of a head-up display according to the present embodiment.

### [Best Mode]

Hereinafter, specific embodiments of the present disclosure will be described in detail with reference to the drawings.

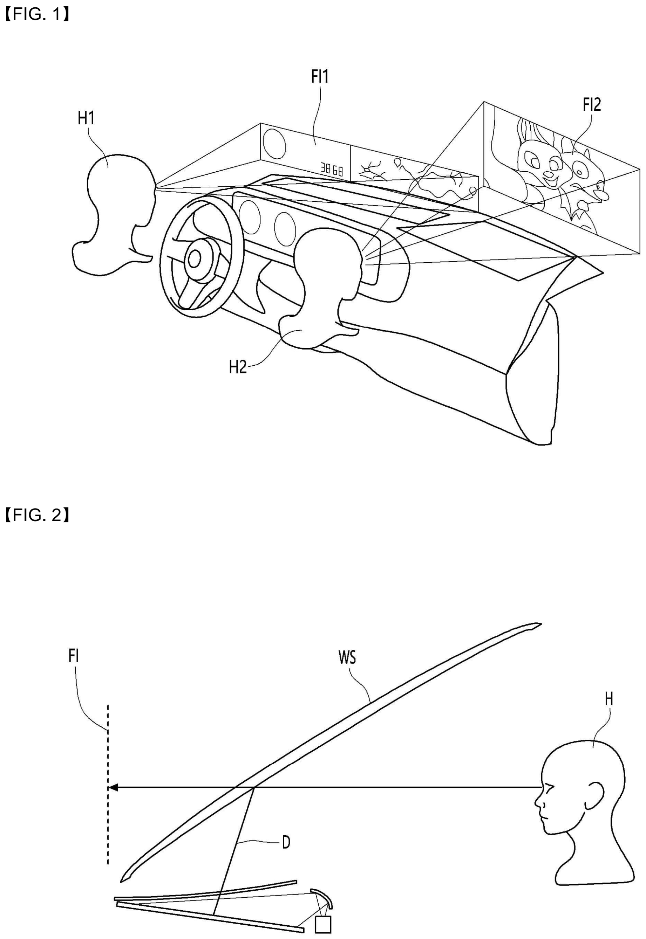

FIG. 1 is a view illustrating a head-up display according to the present embodiment when displaying information, and FIG. 2 is a schematic diagram illustrating a head-up display according to the present embodiment.

A head-up display is installed on the dashboard and can emit image light D toward the windshield WS of the vehicle, so that a occupant H, such as the driver H1 or passenger H2, can recognize a virtual image FI in front of the windshield.

A plurality of head-up displays may be installed on the dashboard, and the plurality of head-up displays may include a first head-up display that provides information FI1 to a driver H1 sitting in the driver's seat, and a second head-up display that provides information FI2 to a passenger H2 sitting in the passenger seat.

An example of a first head-up display may provide a Wide Hover Screen (WHS) for the driver H1.

Another example of a first head-up display may provide an extreme wide hover screen (EWHS). The length of the extreme wide hover screen (EWHS) in the left and right direction may be longer than the length of the wire hover screen in the left and right direction.

The first head-up display can replace the instrument cluster or Corporate Information Display (CID) for a vehicle.

A second head-up display may provide a Passenger Hover Screen (PHS) for the passenger H2in the front passenger seat.

The second head-up display can provide a large-screen virtual infotainment display of 20 inches or more.

The second head-up display can provide device controls such as navigation or air conditioning, entertainment such as music or movies, Internet search, mobile office, or mobile connecting.

A second head-up display can replace the CDD (passenger display).

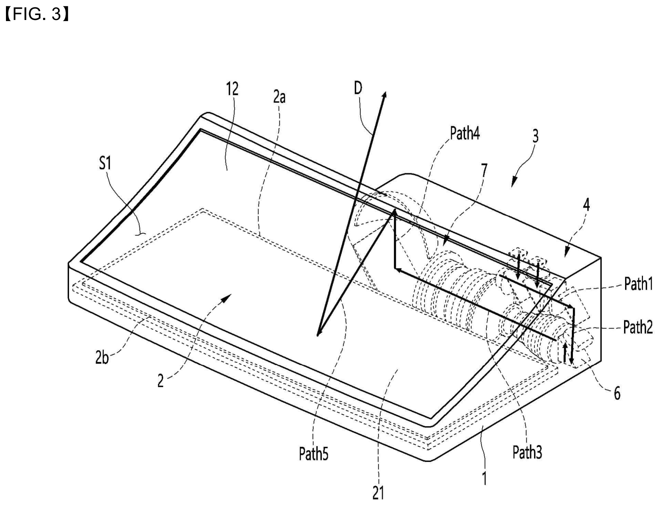

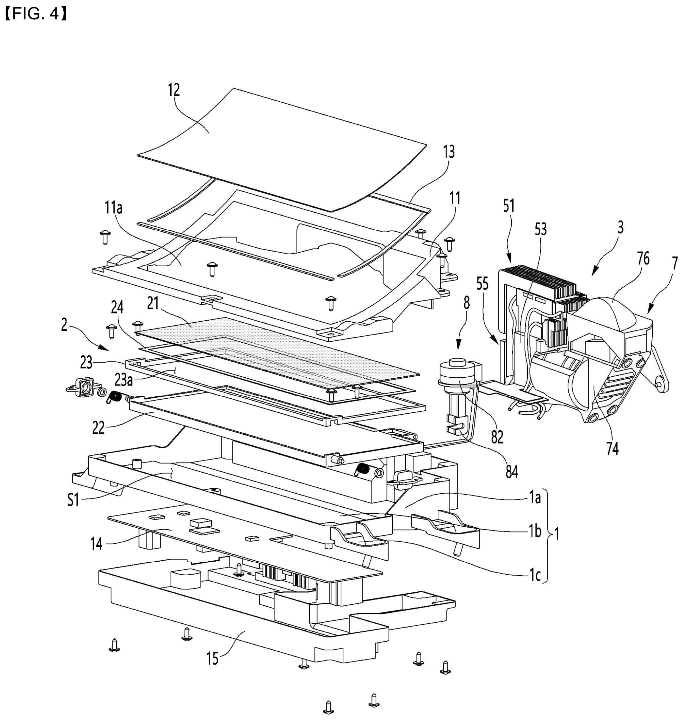

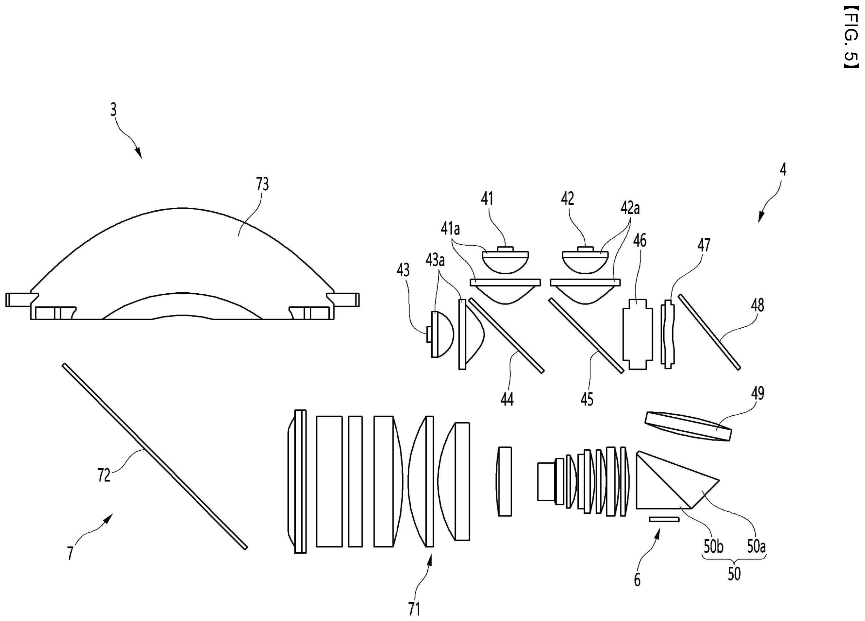

FIG. 3 is a perspective view schematically illustrating an optical path of an example of a head-up display according to the present embodiment, FIG. 4 is an exploded perspective view illustrating an example of a head-up display according to the present embodiment, and FIG. 5 is a rear view illustrating the interior of the image generation part of the head-up display illustrated in FIG. 4.

A head-up display according to the present embodiment may include a housing 1 having a space S1 formed therein; a screen module 2 accommodated in the space S1 and facing a windshield WS; and an image generation part 3 that generates image light D outside the space S1 and projects the image light D onto the screen module 2.

The housing 1 can form an outer appearance of a head-up display.

The upper surface of the housing 1 may be open. The housing 1 may include a peripheral body 1a surrounding the outer periphery of the screen module 2. The housing 1 may include a base plate 1b formed inside the peripheral body 1a. An inner space S1 may be formed by the peripheral body 1a and the base plate 1b. A fastening member 1c that is fastened to a dashboard with a fastening member such as a screw may be formed in the housing 1.

The housing 1 may be made of a metal material. Heat from the image generation part 3 may be transmitted to the housing 1, and the housing 1 may dissipate heat transmitted from the image generation part 3. The housing 1 may be made of a metal material. The housing 1 may be aluminum AL. The housing 1 may be a heat sink that dissipates heat transmitted from the image generation part 3.

A top cover 11 may be placed in the housing 1.

The top cover 11 may be placed on the upper part of the housing 1. The top cover 11 may be fastened to the housing 1 using a fastening member such as a screw. An opening 11a may be formed in the top cover 11. The top cover 11 may be made of polycarbonate PC.

A dust cover 12 can be placed on the top cover 11.

The dust cover 12 may cover the space S1 and prevent foreign substances such as dust from entering the space S1. The dust cover 12 may be attached to the top cover 11 with a double-sided tape 13. The double-sided tape 13 may be polyurethane foam (PU Foam).

The head-up display may include a control board 14 and a bottom cover 15.

A control board 14 can be placed in the housing 1. The control board 14 can control the overall operation of the head-up display. The control board 14 may be fixed to one of the housing 1 and the bottom cover 15. The control board 14 may be placed on the lower surface of the base plate 1a. The control board 14 may be mounted on the base plate 1a using a fastening member such as a screw. The control board 14 can include a main PCB accommodated between the housing 1 and the bottom cover 15.

The bottom cover 15 may be coupled to the housing 1. The bottom cover 15 may be placed on the lower side of the housing 1. The bottom cover 15 can form the outer appearance of the lower surface of the head-up display. The bottom cover 15 can cover the control board 14. The bottom cover 15 can be a PCB cover that protects the main PCB. The bottom cover 15 may be polycarbonate (PC).

The image light projected from the image generation part 3 may be focused on the screen module 2. The screen module 2 can reflect the focused image light D onto the windshield WS.

The screen module 2 may have an approximately rectangular shape. The screen module 2 may have a long side in the left and right direction and a short side in the front and rear direction. The screen module 2 may include one end 2a and the other end 2b, and a distance between the one end 2a and the image generation part 3 may be shorter than a distance between the other end 2b and the image generation part 2b. The one end 2a of the screen module 2 may be a rear end in the front and rear direction of the vehicle. The other end 2a of the screen module 2 may be a front end in the front and rear direction of the vehicle.

The screen module 2 may include a screen 21. Image light D may be focused on the screen 21. The screen 21 may face the windshield WS. The screen 21 may reflect the image light D toward the windshield WS. A Fresnel pattern may be formed on the screen 21. The screen 21 may have an anisotropic micro-Fresnel pattern having directionality and may have a diffusing pattern. The screen 21 may be disposed in the housing 1. The screen 21 may be accommodated in a space S1 of the housing 1 and may reflect the image light D toward the windshield WS. The screen 21 may be composed of a combination of a plurality of members.

The screen module 2 may further include a screen holder 22. The screen holder 22 may support the screen 21. The screen holder 22 may form a frame of the screen module 2. The screen 21 may be placed in the screen holder 22. A space in which the screen 21 is accommodated may be formed in the screen holder 22.

The screen module 2 may further include a screen cover 23. The screen cover 23 may be placed on the upper side of the screen 21. The screen cover 23 may cover the frame of the screen 21. An opening 23a through which image light D passes may be formed in the screen cover 23. The screen cover 23 may be made of polycarbonate (PC).

The screen module 2 may further include a screen tape 24. The screen tape 24 may attach the screen 21 or the screen cover 23 to the screen holder 22. The screen tape 24 may be attached to the screen holder 22. The screen tape 24 may be polyethylene (PE).

The image generation part 3 may include an illumination optical module 4 that generates and irradiates light; an image generator 6 that receives the light irradiated from the illumination optical module 4 and generates image light D; and a projection optical module 7 that projects the image light D generated from the image generator 6 onto the screen module 2.

The image generation part 3 may be a rear image generation part that is disposed on the rear surface of the housing 1 and the rear surface of the top cover 11 and projects image light D toward the screen 21 of the screen module 2.

When the head-up display provides a wide hover screen (WHS), the image generation part 3 may be placed on the rear surface of the housing 1 or the rear surface of the top cover 11.

The image generation part 3 can provide a large screen and use a light emitting diode (LED) or a laser diode to minimize the volume, and can focus image light D on the screen 21 through a projection optical system or a MEMS scanner.

The illumination optical module 4 can generate light and irradiate light to the image generator 6.

The illumination optical module 4 may include a plurality of light sources 41, 42, 43 that irradiate light; a dual band mirror 44, 45 that is less in number than the plurality of light sources 41, 42, 43; a fly-eye lens 46 that divides light and creates a square illumination shape; a first relay lens 47 that collects light divided by the fly-eye lens 46; an illumination conversion mirror 48 that reflects light transmitted through the first relay lens 47; and a second relay lens 49 that collects light reflected by the illumination conversion mirror 49.

Each of the plurality of light sources 41, 42, and 43 may include, for example, a light emitting diode (LED).

Each of the plurality of light sources 41, 42, and 43 may include, as another example, a laser diode (LD).

The plurality of light sources 41, 42, and 43 may include a first light source 41, a second light source 42, and a third light source 43.

The plurality of light sources 41, 42, and 43 may include a first light source 41 that generates a red color laser, a second light source 42 that generates a green color laser, and a third light source 43 that generates a blue color laser.

The first light source 41 may be an R light source that irradiates red light. The first light source 41 may be an R laser light source that generates a red color laser.

The second light source 42 may be a G light source that irradiates green light. The second light source 42 may be a G laser light source that generates a green laser.

The third light source 43 may be a B light source that irradiates blue light. The third light source 43 may be a B laser light source that generates a blue laser.

The light irradiation direction of some 41, 42 of the plurality of light sources 41, 42, and 43 may be different from the light irradiation direction of the remaining light sources 43. The light irradiation direction of at least one 41, 42 of the plurality of light sources 41, 42, and 43 may be different from the light irradiation direction of another 43 of the plurality of light sources 41, 42, and 43.

The first light source 41 and the second light source 42 may be disposed in parallel.

Each of the first light source 41 and the second light source 42 can irradiate light in a vertical direction. Each of the first light source 41 and the second light source 42 can irradiate light in a lower direction.

The third light source 43 can irradiate light in the left and right direction. The third light source 43 can irradiate light in the lower direction from the first light source 41 and the second light source 42.

The R light irradiated from the first light source 41, the G light irradiated from the second light source 42, and the B light irradiated from the third light source 43 can pass through the dual-band mirror or be reflected by the dual-band mirror and be synthesized.

A plurality of dual-band mirrors 44 and 45 may be provided. The plurality of dual-band mirrors 44 and 45 can form a synthetic optical system that synthesizes R light, B light, and B light.

The plurality of dual-band mirrors 44 and 45 may include a first dual-band mirror 44 and a second dual-band mirror 45.

An example of the first dual-band mirror 44 may be a dichroic mirror made of many thin layers of materials having different refractive indices, reflecting light of a certain color and transmitting all light of other colors.

The first dual band mirror 44 reflects R light generated from the first light source 41 and allows B light generated from the third light source 43 to pass through. The first dual band mirror 44 may be disposed below the first light source 41. The first dual band mirror 44 may be disposed next to the third light source 43. The first dual band mirror 44 may be disposed at a set angle.

An example of a second dual-band mirror 45 may be a dichroic mirror made of many thin layers of materials having different refractive indices, reflecting light of a certain color and transmitting all light of other colors.

The second dual band mirror 44 reflects the G light generated from the second light source 42 and allows the R light generated from the first light source 41 and the B light generated from the third light source 43 to be transmitted. The second dual band mirror 45 may be disposed below the second light source 42. The second dual band mirror 45 may be disposed next to the first dual band mirror 44. The second dual band mirror 45 may be disposed at a set angle.

The illumination optical module 4 may further include at least one first collimating lens 41a disposed between the first light source 41 and the first dual-band mirror 44 to focus light.

The illumination optical module 4 may further include at least one second collimating lens 42a disposed between the second light source 42 and the second dual-band mirror 45 to focus light.

The illumination optical module 4 may further include at least one third collimating lens 43a disposed between the third light source 43 and the first dual-band mirror 44 to focus light.

A fly-eye lens 46 may be placed next to the second dual-band mirror 44 and can split the synthesized three-color light into multiple pieces and create a square illumination shape.

The first relay lens 47 may be placed between the fly eye lens 46 and the illumination conversion mirror 48.

The illumination conversion mirror 48 can reflect light transmitted through the first relay lens 47 downward. The illumination conversion mirror 48 can be a conversion mirror that converts an optical path. The illumination conversion mirror 48 can convert light transmitted through the first relay lens 47 in a downward direction or a downward inclined direction. The illumination conversion mirror 48 may be disposed to be inclined, like the dual-band mirror 44, 45.

The second relay lens 49 may be placed below the first relay lens 47 and the illumination conversion mirror 48. The second relay lens 49 can collect light reflected by the illumination conversion mirror 48 onto a prism 50.

The illumination optical module 4 may further include a prism 50. The prism 50 may be placed between the second relay lens 49 and the image generator 6.

The prism 50 can transmit light transmitted through the second relay lens 49 to the image generator 6 and can reflect the image light generated from the image generator 6 to the projection optical module 7.

The prism 50 may include a first prism 50a facing the second relay lens 49 and a second prism 50b coupled with the first prism 50a and facing the image generator 6 and the projection optical module 7.

The first prism 50a may be placed above the second prism 50b. The first prism 50a may include a lower surface facing the image generator 6, a side surface facing the projection optical module 7, and an inclined surface facing the second prism 50b.

The second prism 50b may include an inclined surface facing the first prism 50b, an upper surface facing the second relay lens 49, and a side surface orthogonal to the upper surface.

Light passing through the second relay lens 49 can sequentially transmit through the second prism 50b and the first prism 50a.

The boundary surface (that is, inclined surface) of the first prism 50a and the second prism 50b can be a transmission surface through which light transmitted through the second relay lens 49 is transmitted, and can be a reflection surface that reflects the image light generated from the image generator 6 to the projection optical module 7.

At least a part of the light path (Path 1) (Path 2) of the illumination optical module 4 may be parallel to one end 2a of the screen module 2.

The light path (Path 1) (Path 2) of the illumination optical module 4 may include a first light path (Path 1) that is long in the left and right direction and a second light path (Path 2) that is orthogonal to the first light path (Path 1) and inclined at a predetermined angle with respect to the first light path (Path 1).

The first optical path (Path 1) may be parallel to one end 2a of the screen module 2.

The third light source 43, the first dual-band mirror 44, the second dual-band mirror 45, the fly-eye lens 46, the first relay lens 47, and the illumination conversion mirror 48 may be disposed in a row in the left and right direction and can form a first light path (Path 1).

The third light source 43, the first dual-band mirror 44, the second dual-band mirror 45, the fly-eye lens 46, the first relay lens 47, and the illumination conversion mirror 48 may be disposed in a row on the first light path (Path 1).

The illumination conversion mirror 48, the second relay lens 49, and the prism 50 can form a second optical path (Path 2). The illumination conversion mirror 48, the second relay lens 49, and the prism 50 may be disposed in a row on the second optical path (Path 2).

The image generator 6 may be disposed on the lower side of the illumination optical module 4. The image generator 6 may be disposed on the lower side of the prism 50. The illumination conversion mirror 48, the second relay lens 49, the prism 50, and the image generator 6 may be disposed in a row on the second optical path (Path 2).

The image generator 6 can generate image light by receiving light transmitted through a prism 50.

Examples of image generators 6 may include projection optics or micro electro mechanical systems (MEMS) scanners (hereinafter referred to as MEMS scanners).

MEMS scanners can control the incident laser beam in a desired direction by rotating a reflection mirror using voltage.

Ultra-short-focus optical systems have high magnification, making them difficult to design and sensitive to temperature, whereas MEMS scanners are focus-free optical systems that can easily implement focusing performance.

Light emitted from the first light source 41, the second light source 42, and the third light source 43 is synthesized through a condensing lens (for example, a collimating lens) and a synthetic optical system, and the synthesized laser light can be incident on a MEMS scanner and reflected, and can be scanned and imaged on the surface of a screen 21.

When the image light generated by the MEMS scanner is focused on the screen 21, the structure of the image generation part 3 can be simpler than when an ultra-short-focus optical system is applied, and the volume of the image generation part 3 can be minimized.

The illumination optical module 4 and the image generator 6 can constitute an optical module that generates image light D.

The projection optical module 7 may include at least one projection lens 71; a projection conversion mirror 72 (Folding Mirror) that reflects image light D transmitted through the projection lens 71; and a concave mirror 73 that expands image light D reflected from the projection conversion mirror 72 to the screen module 2.

The projection lens 71 can be placed between the prism 50 and the projection conversion mirror 72. The projection lens 71 can form a large screen by enlarging and projecting a small image through the lens 2.

The projection lens 71 may include a plurality of lenses disposed in a row, and the plurality of lenses may be disposed in a row in the left and right direction.

The projection conversion mirror 72 can be configured to make the image generation part 3 as compact as possible. The projection conversion mirror 72 can be a conversion mirror that converts an optical path. The projection conversion mirror 72 can convert image light transmitted through the projection lens 71 to an upper direction. The projection conversion mirror 72 can be parallel to the illumination conversion mirror 48. The projection conversion mirror 72 can reflect image light transmitted through the projection lens 71 to a concave mirror 73.

The concave mirror 73 may be placed on the upper side of the projection conversion mirror 72. The concave mirror 73 can reflect the image light D to the upper surface of the screen 21.

At least a part (Path 3) of the optical path (Path 3)(Path 4)(Path 5) of the projection optical module 7 may be parallel to one end 2a of the screen module 2.

The optical path (Path 3)(Path 4)(Path 5) of the projection optical module 7 may include a third optical path (Path 3) that is long in the left and right direction and a fourth optical path (Path 4) that is inclined at a predetermined angle or bent orthogonally to the third optical path (Path 3).

The third optical path (Path 3) may be parallel to one end 2a of the screen module 2.

A plurality of projection lenses 71 and a projection conversion mirror 72 can form a third optical path (Path 3).

The projection transformation mirror 72 and the concave mirror 73 can form a fourth optical path (Path 4).

The optical path (Path 3)(Path 4)(Path 5) of the projection optical module 7 may further include a fifth optical path (Path 5) through which light reflected from the concave mirror 73 is directed to the screen 21.

It is preferable that the image generation part 3 be placed as compactly as possible outside the housing 1, and it is preferable that the width in the left and right direction and the height in the vertical direction of the image generation part 3 be minimized.

The illumination optical module 4 can be disposed in approximately an '¬' shape, and the projection optical module 7 can be disposed in approximately an 'L' shape.

A part of the illumination optical module 4 may be placed in an area next to the concave mirror 73 and above the projection lens 71.

A plurality of light sources 41, 42, and 43 and dual band mirrors 44 and 45 may be placed in an area next to the concave mirror 73 and above the projection lens 71.

Another part of the illumination optical module 4 may be placed in an area next to the projection lens 71.

The second relay lens 49 and prism 50 can be placed in an area next to the projection lens 71.

The projection transformation mirror 72 can be placed in an area next to the projection lens 71 and below the concave mirror 73.

It is preferable that the lower part of the illumination optical module 4 be positioned next to the projection lens 71.

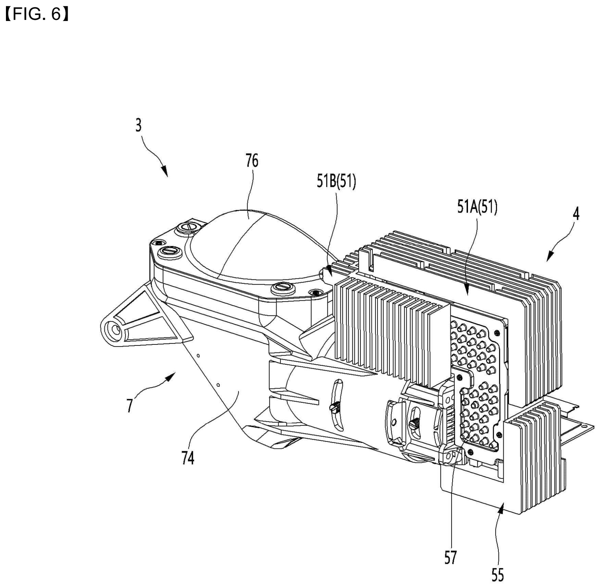

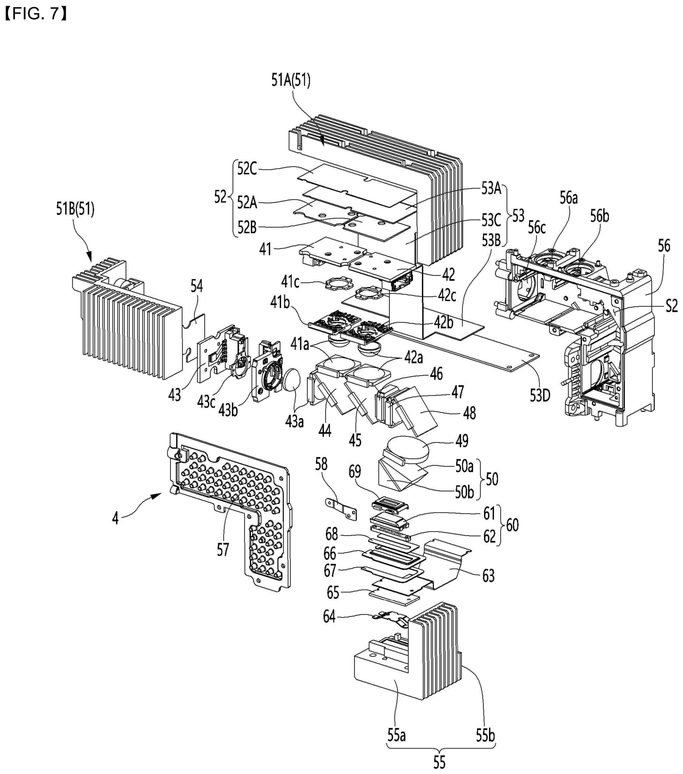

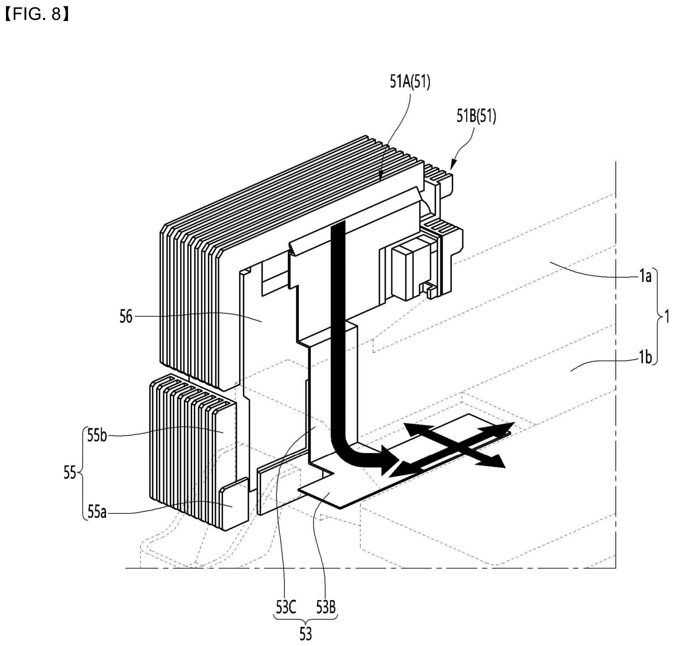

FIG. 6 is a perspective view illustrating an image generation part according to the present embodiment, FIG. 7 is an exploded perspective view illustrating the illumination optical module according to the present embodiment, and FIG. 8 is a perspective view illustrating an illumination optical module and a housing according to the present embodiment.

Each of the first light source 41, the second light source 42, and the third light source 43 may include a substrate and an optical element mounted on the substrate. An example of the optical element may be an LED diode.

The first light source 41 may further include a first light source holder 41b that fixes the substrate. The first light source 41 may further include a rubber holder 41c disposed between the substrate and the first light source holder 41b.

The second light source 42 may further include a second light source holder 42b that fixes the substrate. The second light source 42 may further include a rubber holder 42c disposed between the substrate and the second light source holder 42b.

The third light source 43 may further include a third light source holder 43b that fixes the substrate. The third light source 43 may further include a rubber holder 43c disposed between the substrate and the third light source holder 43b.

The image generation part 3 may include a heat dissipation device. The heat dissipation device may dissipate heat from a plurality of light sources 41, 42, and 43 and heat from the image generator 6.

The heat dissipation device may include an illumination heat dissipation part 51. The illumination heat dissipation part 51 may dissipate heat of the illumination optical module 4. The illumination heat dissipation part 51 may dissipate heat of a plurality of light sources 41, 42, and 43.

The illumination heat dissipation part 51 may include a heat sink having a plurality of fins formed therein and may dissipate heat into the air.

A plurality of illumination heat dissipation parts 51 may be provided. The plurality of illumination heat dissipation parts 51 may include a first heat dissipation part 51A and a second heat dissipation part 51B.

At least one of the first heat dissipation part 51A and the second heat dissipation part 51B can dissipate heat from the plurality of light sources.

The number of light sources radiated by the first heat dissipation part 51A and the number of light sources radiated by the second heat dissipation part 51B may be different. The number of light sources radiated by the first heat dissipation part 51A may be greater than the number of light sources radiated by the second heat dissipation part 51B.

The first heat dissipation part 51A can dissipate heat from at least one of the plurality of light sources 41, 42, and 43. The first heat dissipation part 51A can dissipate heat from two laser light sources 41 and 42.

The second heat dissipation part 51B can dissipate heat from another one of the plurality of light sources 41, 42, and 43. The other one of the plurality of light sources 41, 42, and 43 can be the remaining light source 43 among the plurality of light sources 41, 42, and 43 that is not dissipated heat by the first heat dissipation part 51A. The second heat dissipation part 51B can dissipate heat from one laser light source.

The first heat dissipation part 51A can dissipate heat from a relatively high-temperature light source among the first light source 41, the second light source 42, and the third light source 43. The first light source 41 may be more vulnerable to heat than other laser light sources 42 and 43.

The first heat dissipation part 51A can dissipate heat from a light source that is relatively vulnerable to heat among the first light source 41, the second light source 42, and the third light source 43. The second light source 42 can have higher power than other laser light sources 42 and 43.

The first heat dissipation part 51A can dissipate heat from the first light source 41 and the second light source 42 together.

The first heat dissipation part 51A can be in thermal contact with each of the first light source 41 and the second light source 42.

The first heat dissipation part 51A may include a first heat sink having a plurality of fins formed thereon. The first heat dissipation part 51A may further include a thermal pad 52. The first heat dissipation part 51A may further include a heat dissipation connector 53.

The first heat sink can be in thermal contact with the heat dissipation connector 53. A part of the heat conducted to the heat dissipation connector 53 can be transferred to the first heat sink and dissipated from the first heat sink to the atmosphere.

A thermal pad 52 may be placed between the first heat sink and the first light source 41 and between the first heat sink and the second light source 42.

At least one thermal pad 52 may be provided. A plurality of thermal pads 52 may be provided. The plurality of thermal pads 52 may include a first thermal pad 52A, a second thermal pad 52B, and a third thermal pad 52C.

The first thermal pad 52A may be placed on the first light source 41. The first thermal pad 52A may be placed on the upper surface of the first light source 41. The first thermal pad 52A may be an R thermal pad. The first thermal pad 52A may be placed between the first light source R and the heat dissipation connector 53.

The second thermal pad 52B may be placed on the second light source 42. The second thermal pad 52B may be placed on the upper surface of the second light source 42. The second thermal pad 52B may be a G thermal pad. The second thermal pad 52B may be placed between the second light source G and the heat dissipation connector 53.

The third thermal pad 52C may be placed on the first heat sink. The third thermal pad 52C may be in contact with the first heat sink. The third thermal pad 52C may be a common thermal pad that transfers the heat of the first light source 41 and the heat of the second light source 42 to the first heat sink. The third thermal pad 52C may be placed between the heat dissipation connector 53 and the first heat sink.

The heat dissipation connector 53 can constitute the first heat dissipation part 51A and can be a part of the first heat dissipation part 51A. The heat dissipation connector 53 can transfer heat of the illumination optical module 4 to the housing 1. The heat dissipation connector 53 can be a heat transfer member that transfers heat of the illumination optical module 4 to the housing 1. An example of the heat dissipation connector 53 may be a copper plate. The heat dissipation connector 53 can transfer heat of the first light source 41 and the second light source 42 to the housing 1. The heat dissipation connector 53 may be in thermal contact with each of the first light source 41 and the second light source 42 among the plurality of light sources 41, 42, and 43. The heat dissipation connector 53 may be in thermal contact with the housing 1.

The heat dissipation connector 53 may include a thermal contact body 53A that comes into contact with the thermal pad 52, a housing contact body 53B that comes into contact with the housing 1, and a connecting body 53C that connects the thermal contact body 53A and the housing contact body 53B.

The thermal contact body 53A can be in contact with each of the first thermal pad 52A, the second thermal pad 52B, and the third thermal pad 52C.

The lower surface of the thermal contact body 53A may be in contact with each of the first thermal pad 52A and the second thermal pad 52B. The upper surface of the thermal contact body 53A may be in contact with the third thermal pad 52C. The thermal contact body 53A may be a heat absorbing body that is in contact with the thermal pad 52 and absorbs heat transferred from the first light source 41 and heat transferred from the second light source 42.

The housing contact body 53B may be positioned inside the housing 1. The housing contact body 53B may be a housing contact body that comes into contact with the housing 1. The housing contact body 53B may come into contact with the base plate 1b of the housing 1. The housing contact body 53B may be a heat dissipation body that transfers heat transferred from the first light source 41 and heat transferred from the second light source 42 to the housing 1.

The housing contact body 53B may be covered by a cover plate 53D. The cover plate 53D may be electro-galvanized steel (SECC). The cover plate 53D may be fastened to the housing 1 by a fastening member such as a screw. The cover plate 53D may cover the housing contact body 53B from the lower side of the housing contact body 53B. The cover plate 53D may constitute a first heat dissipation part 51A. The cover plate 53D may be a part of the first heat dissipation part 51A.

The connecting body 53B can be formed to be long in the vertical direction and can transfer heat of the thermal contact body 53A to the housing contact body 53B. The connecting body 53B can be bent with each of the thermal contact body 53A and the housing contact body 53B. The connecting body 53B can be in contact with the peripheral body 1a of the housing 1. The connecting body 53B can be a heat dissipation body that transfers heat transferred from the first light source 41 and heat transferred from the second light source 42 to the housing 1.

The heat dissipation connector 53 can transfer heat conducted from the first light source 41 and the second light source 42 through the thermal contact body 53A to the housing 1 through the housing contact body 53B, and the heat transferred to the housing 1 can be diffused into the housing 1.

The housing 1 in contact with the heat dissipation connector 53 can function as a heat sink that dissipates the heat of the first light source 41 and the heat of the second light source 42, and damage to the first light source 41 or the second light source 42 due to heat can be minimized.

The heat from the first light source 41 and the second light source 42 can be conducted to the first heat dissipation part 51A through the thermal contact body 53A and can be dissipated from the first heat dissipation part 51A to the atmosphere.

The heat from the first light source 41 and the second light source 42 can be conducted to the housing 1 through the heat dissipation connector 53 and can be dissipated from the housing 1 to the atmosphere.

The first light source 41 and the second light source 42 can be efficiently dissipated by the first heat dissipation part 51A and the housing 1, respectively.

The second heat dissipation part 51B can dissipate heat from the third light source 43 among the plurality of light sources 41, 42, and 43. The second heat dissipation part 51B can include a second heat sink in thermal contact with the third light source 43 among the plurality of light sources 41, 42, and 43. The size of the second heat sink may be smaller than the size of the first heat sink.

The second heat dissipation part 51B can dissipate heat from the third light source 43. The second heat dissipation part 51B can be in thermal contact with the third light source 43. The second heat dissipation part 51B can further include a thermal pad 54 disposed between the third light source 43 and the second heat dissipation sink. The thermal pad 54 can be a fourth thermal pad that is different from the first thermal pad 52A, the second thermal pad 52B, and the third thermal pad 52C.

An example of a second heat dissipation part 51B may be spaced apart from the first heat dissipation part 51A. Another example of a second heat dissipation part 51B may be in thermal contact with the first heat dissipation part 51A.

The image generation part 3 may include an image generator heat dissipation part 55.

The image generator heat dissipation part 55 can dissipate heat from the image generator 6. The image generator heat dissipation part 55 can be in thermal contact with the image generator 6. The image generator heat dissipation part 55 can include a heat sink in thermal contact with the image generator (DMD). The heat sink of the image generator heat dissipation part 55 can have a plurality of fins formed therein and can dissipate heat into the air.

The heat sink of the image generator heat dissipation part 55 may be a third heat sink different from the first heat sink and the second heat sink. The heat sink of the image generator heat dissipation part 55 may be in thermal contact with at least one of the first heat dissipation part 51A and the second heat dissipation part 51B.

The illumination optical module 4 may further include a base 56 and a cover 57.

A space S2 may be formed in one of the base 56 and the cover 57, and the other of the base 56 and the cover 57 can cover the space S2. The space S2 may be formed inside the base 56, and the cover 57 may cover the space S2.

A plurality of light sources 41, 42, and 43 may be placed on the base 56.

A plurality of light sources 41, 42, and 43 may be placed on the outer surface of the base 56.

A holder mounting part in which a first light source holder 41b of a first light source 41 is mounted and a first light transmitting hole 56a through which R light irradiated from the first light source 41 is transmitted may be formed on the base 56. The first light source 41 may be placed on the upper surface of the base 56.

A holder mounting part in which a second light source holder 42b of a second light source 42 is mounted and a second light transmitting hole 56b through which G light irradiated from the second light source 42 is transmitted may be formed on the base 56. The second light source 42 may be placed on the upper surface of the base 56.

A holder mounting part in which a third light source holder 43b of a third light source 43 is mounted and a third light transmitting hole 56c through which B light irradiated from the third light source 43 is transmitted may be formed on the base 56. The third light source 43 may be placed on one side of the base 56.

The space S2 can accommodate all or part of the illumination optical module 4.

A space S2 can accommodate a plurality of collimating lenses 41a, 42a, and, 43a; a dual-band mirror 44(45); a fly-eye lens 46; a first relay lens 47; a illumination conversion mirror 48; and a second relay lens 49; and a prism 50.

A plurality of collimating lenses 41a, 42a, and, 43a; a dual-band mirror 44(45); a fly-eye lens 46; a first relay lens 47; a illumination conversion mirror 48; and a second relay lens 49 may be a plurality of optical elements that guide light irradiated from a plurality of light sources 41, 42, and 43 to an image generator 6.

A prism 50 can transmit light transmitted through a plurality of optical elements to an image generator 6 and reflect image light generated from the image generator 6.

A plurality of optical elements and prisms 50 can be accommodated in the space S2.

A prism retainer 58 for fixing a prism 50 can be accommodated in the space S2.

The prism retainer 58 may be fastened to either the base 56 or the cover 57.

An image generator 6 can be accommodated in the space S2. The image generator 6 can be accommodated in the space S2 and protected by a base 56 and a cover 57.

The image generator 6 may include a digital micromirror device 61(DMD), an interposer 62, and a flexible circuit board 63.

The digital micromirror device 61 may have at least one built-in micromirror.

An interposer 62 may protrude downward from the lower surface of a digital micromirror device 61. The interposer 62 may be connected to a flexible circuit board 63.

The image generation part 3 may further include a spring 64 and a lower clamp 65 disposed between the heat sink (that is, the third heat sink) of the image generator heat dissipation part 55 and the flexible circuit board 63.

A spring 64 may be placed between the heat sink (that is, the third heat sink) of the image generator heat dissipation part 55 and the lower clamp 65.

The lower clamp 65 can be placed between the spring 64 and the flexible circuit board 63.

The image generator 6 may further include an upper clamp 66 positioned between the digital micromirror device 61 and the flexible circuit board 63.

The image generator heat dissipation part may include at least one thermal pad 66, 67. The at least one thermal pad 66, 67 may be disposed between the image generator 6 and a heat sink (that is, a third heat sink). A plurality of thermal pads may be provided. The plurality of thermal pads may further include an upper thermal pad 67 and a lower thermal pad 68.

The upper thermal pad 67 can be in contact with the lower surface of the digital micromirror device 61. The upper thermal pad 67 can be a fourth thermal pad that is different from the first thermal pad 52A, the second thermal pad 52B, and the third thermal pad 55.

The upper clamp 66 may be placed between the upper thermal pad 67 and the lower thermal pad 68.

The lower thermal pad 68 can be in contact with the upper surface of the flexible circuit board 63. The lower thermal pad 68 can be a fifth thermal pad that is different from the first thermal pad 52A, the second thermal pad 52B, the third thermal pad 55, and the fourth thermal pad.

A rubber 69 may be placed on the upper surface of the digital micromirror device 61.

An example of the image generator heat dissipation part 55 may be spaced apart from each of the first heat dissipation part 51A and the second heat dissipation part 51B. Another example of the image generator heat dissipation part 55 may be in thermal contact with at least one of the first heat dissipation part 51A and the second heat dissipation part 51B.

The illumination heat dissipation part 51 and the image generator heat dissipation part 55 may be placed outside the base 56. The illumination heat dissipation part 51 and the image generator heat dissipation part 55 may be exposed to the outside of the base 56 and the cover 57.

The first heat dissipation part 51A can cover the upper surface of the base 56 and the upper part of one side of the base 56. The first heat dissipation part 51A can have a bent shape. The first heat dissipation part 51A can include an upper body covering the upper surface of the base 56 and a side body covering the upper part of one side of the base 56.

The second heat dissipation part 51B can cover the other side of the base 56 and a part of the cover 57. The second heat dissipation part 51B can have a bent shape. The second heat dissipation part 51B can include a side body covering the other side of the base 56 and a rear body covering a part of the cover 57.

The image generator heat dissipation part 55 can cover the lower surface of the base 56 and the lower part of one side surface of the base 56. The image generator heat dissipation part 55 can have a bent shape. The image generator heat dissipation part 55 can include a lower body 55a covering the lower surface of the base 56 and a side body 55b covering the lower part of one side surface of the base 56.

A heat dissipation part combination 51A, 51B, 55 composed of a first heat dissipation part 51A, a second heat dissipation part 51B, and an image generator heat dissipation part 55 can cover a part of the outer surface of the illumination optical module 4.

A heat dissipation part combination 51A, 51B, 55 composed of a first heat dissipation part 51A, a second heat dissipation part 51B, and an image generator heat dissipation part 55 can cover the upper surface, left and right sides, and the lower surface of the base 56, and can cover the rear surface of the cover 57.

The illumination optical module 4, the image generator 6, and the heat dissipation part combination 51A, 51B, 55 can constitute an optical module that generates image light D.

These optical modules can be fastened to the projection optical module 7 by a fastening member such as a screw from the side of the projection optical module 7. A fastening member that can be fastened to the projection optical module 7 by a fastening member such as a screw can be formed on the illumination optical module 4. The fastening member may be formed on at least one of the base 56 and the cover 57.

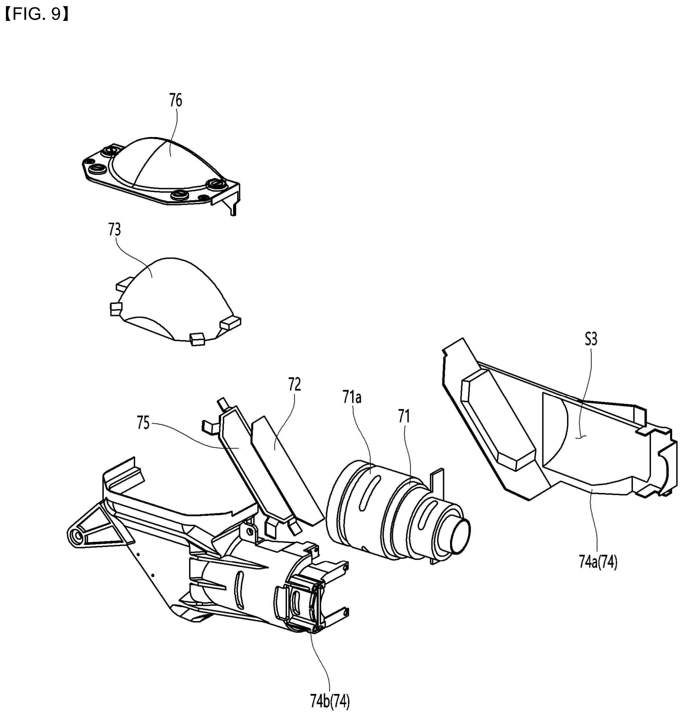

FIG. 9 is an exploded perspective view of a projection optical module according to the present embodiment.

The projection optical module 7 may further include a bottom case 74 in which a projection lens 71 is accommodated; a mirror holder 75 in which a projection conversion mirror 72 is disposed and disposed in the bottom case 74; and a top case 76 covering a concave mirror 73.

A space S3 in which a projection lens 71 and a projection conversion mirror 72 are accommodated can be formed in the bottom case 74.

The projection lens 71 may include a lens housing 71a in which a plurality of lenses are accommodated. The projection optical module 7 may include a lens assembly, and the lens assembly may include a lens housing 71a and a plurality of lenses accommodated in the lens housing 71a.

A lens assembly may be accommodated in the bottom case 74, and a concave mirror 73 may be supported in the bottom case 74. The concave mirror 73 may be seated in the bottom case 74.

The bottom case 74 may include a front bottom case 74a and a rear bottom case 74b coupled to the front bottom case 74a. The front bottom case 74a and the rear bottom case 74b may be coupled using a fastening member such as a screw.

A space S3 in which a projection lens 71 and a projection conversion mirror 72 are accommodated may be formed between a front bottom case 74a and a rear bottom case 74b. A space S3 in which a projection lens 71 and a projection conversion mirror 72 are accommodated can be formed in each of the front bottom case 74a and the rear bottom case 74b.

A fastening part may be formed in the bottom case 74 to which the illumination optical module 4 may be fastened using a fastening member such as a screw. An example of the fastening member may be a fastening boss. The fastening part may be formed in each of the front bottom case 74a and the rear bottom case 74b.

The mirror holder 75 can support the projection conversion mirror 72. The mirror holder 75 can be accommodated in the space S3 of the bottom case 74 together with the projection conversion mirror 72. The mirror holder 75 can be a middle case disposed between the front bottom case 74a and the rear bottom case 74b.

The top case 76 may be coupled to at least one of the bottom case 74 and the mirror holder 75. The top case 76 can protect the concave mirror 73 from the upper side of the concave mirror 73. The top case 76 may be mounted on the upper part of the concave mirror.

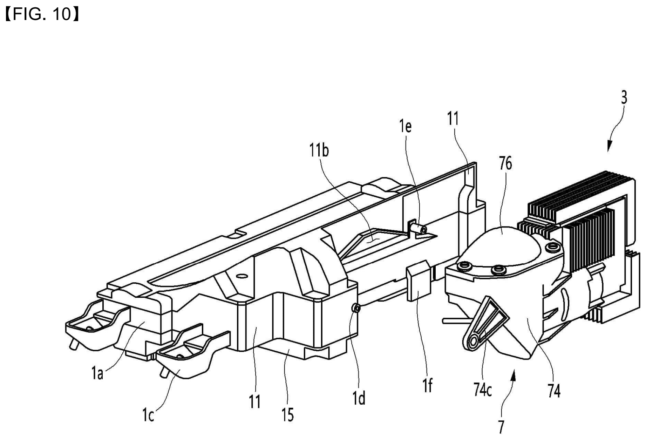

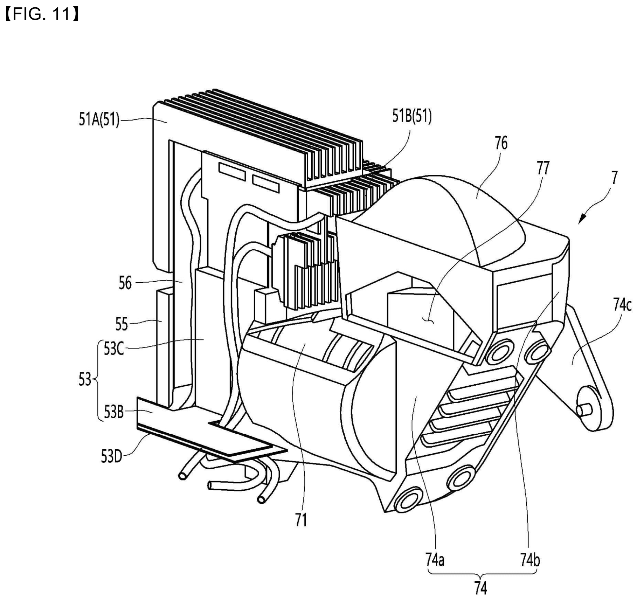

FIG. 10 is a perspective view illustrating a light transmitting part formed on a housing or a top cover according to the present embodiment, and FIG. 11 is a perspective view illustrating a light transmitting part of an image generation part according to the present embodiment.

The illumination optical module 4 can be fixed to the projection optical module 7. The projection optical module 7 can be fixed to the back or side surface of at least one of the housing 1 and the top cover 11.

The projection optical module 7 may include a fastening body 74c fastened to at least one of the housing 1 and the top cover 11. The fastening body 74c may be formed on the bottom case 74. The fastening body 74c may be formed on at least one of the front bottom case 74a and the rear bottom case 74b. The fastening body 74c may be fastened to at least one of the housing 1 and the top cover 11 using a fastening member such as a screw.

At least one of the housing 1 and the top cover 11 may be formed with a fastening part 1d, 1e to which the projection optical module 7 is fastened using a fastening member such as a screw. An example of the fastening member 1d, 1e may be a fastening boss. A plurality of fastening members 1d, 1e may be provided on the housing 1. The plurality of fastening members 1d, 1e may include a lower fastening members 1d formed to protrude rearwardly on a lower part of the back surface of the housing 1, and an upper fastening member 1e formed to protrude rearwardly on an upper part of the back surface of the housing 1. The lower fastening part 1d and the upper fastening part 1e may protrude from the peripheral body 1a of the housing 1.

At least one of the housing 1 and the top cover 11 may be formed with a position determining part 1f that determines the position of the projection optical module 7. The position determining part 1f may be formed on the housing 1. The position determining part 1f may be spaced apart from the fastening part 1d, 1e. The projection optical module 7 may be caught on the position determining part 1f.

The projection optical module 7 may be assembled by being restrained to the position determining part 1f, and then fastened to the fastening part 1d, 1e using a fastening member such as a screw.

A first light transmitting part 77 through which image light is transmitted may be formed in the image generation part 3. The first light transmitting part 77 may be formed in the projection optical module 7.

Image light D reflected from the concave mirror 73 can escape to the outside of the projection optical module 7 through the first light transmitting part 77.

The first light transmitting part 77 may be a light projection path through which image light D is projected outside the projection optical module 7. An example of the first light transmitting part 77 may be an opening through which image light is transmitted. The first light transmitting part 77 may be formed in at least one of the top case 76 and the bottom case 74, or may be formed between the top case 76 and the bottom case 74.

The portion surrounding the first light transmitting part 77 of the projection optical module 7 may be a light shielding part.

The first light transmitting part 77 may be formed in the top case 76, and a light transmitting part 77 through which image light enlarged by the concave mirror 73 is projected onto the screen 21 can be formed in the top case 76.

At least one of the housing 1 and the top cover 11 may be formed with a second light transmitting part 11b through which image light D transmitted through the first light transmitting part 77 is transmitted.

The second light transmitting part 11b may be a light inflow path through which image light D is introduced into the interior of the housing 1. An example of the second light transmitting part 11b may be an opening through which image light is transmitted. The second light transmitting part 11b may be formed in at least one of the housing 1 and the top cover 11, or may be formed between the housing 1 and the top cover 11.

The portion around the second light transmitting part 11b of the housing 1 and the top cover 11 may be a light shielding part.

The image light D reflected from the concave mirror 73 may form an optical intersection inside the projection optical module 7. The optical intersection may be formed on the lower side of the concave mirror 73.

The size of the first light transmitting part 77 may be larger than the size of the second light transmitting part 11b.

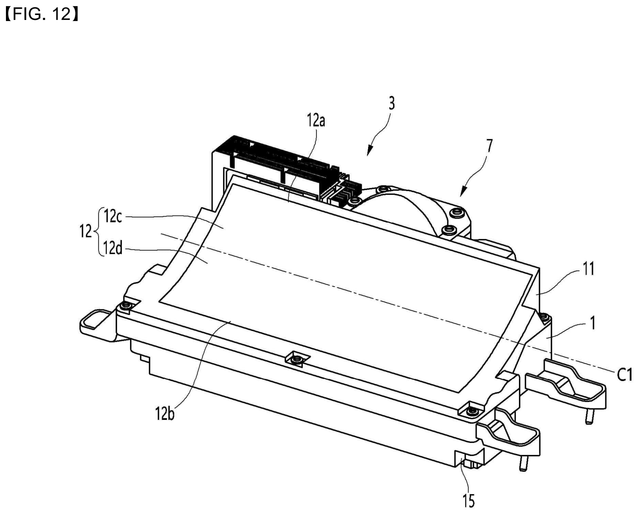

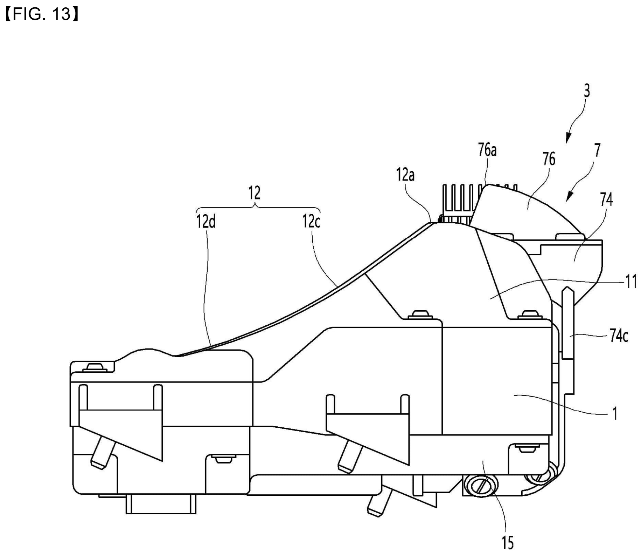

FIG. 12 is a perspective view illustrating a head-up display according to the present embodiment, and FIG. 13 is a side view illustrating a head-up display according to the present embodiment.

The dust cover 12 may have one end 12a and the other end 12b. The one end 12a of the dust cover 12 may be the end part of the dust cover 12 that is closest to the image generation part 3. The other end 12b of the dust cover 12 may be the end part of the dust cover 12 that is farthest from the image generation part 3. The space between the one end 12a of the dust cover 12 and the other end 12b of the dust cover 12 may be formed to have a curvature. The height of the one end 12a of the dust cover 12 may be higher than the height of the other end 12b thereof. The one end 12a of the dust cover 12 may be positioned on the upper rear side of the dust cover 12. The space between the one end 12a and the other end 12b of the dust cover 12 can be concave downward and the dust cover can minimize the back reflection of sunlight.

The dust cover 12 may include a near area 12c and a far area 12d.

The near area 12c may be an area close to the image generation part 3 among the dust covers 12. The distance between the near area 12c and the image generation part 3 may be shorter than the distance between the far area 12d and the image generation part 3.

When the dust cover 12 is divided into two areas based on the center line C1, the near area 12c may be the area between the center line C1 and one end 12a of the dust cover 12.

The center line C1 dividing the dust cover 12 can be long in the left and right directions.

The height of the near area 12c may be higher than the height of the far area 12d.

The far area 12d may be an area of the dust cover 12 that is far from the image generation part 3.

When the dust cover 12 is divided into two areas based on the center line C1, the far area 12d may be the area between the center line C1 and the other end 12b of the dust cover 12.

The upper height of the projection optical module 7 may be higher than the height of one end 12a of the dust cover 12. The upper height (76a) of the top case 76 may be higher than the height of one end 12a of the dust cover 12.

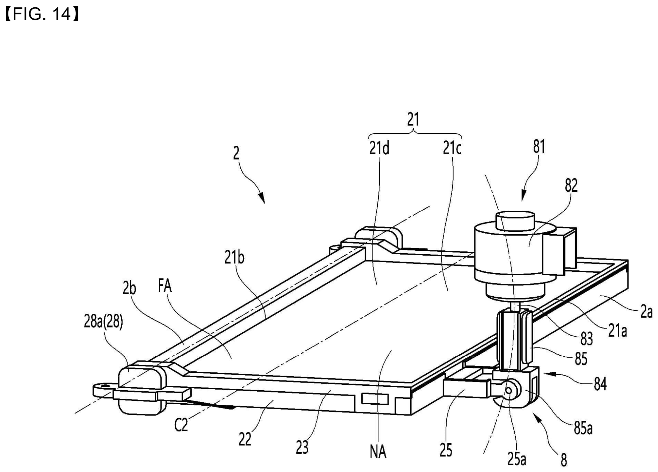

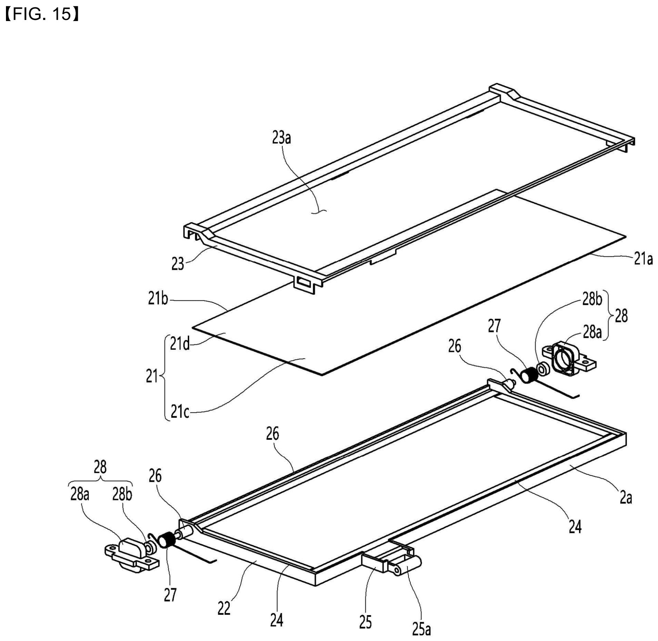

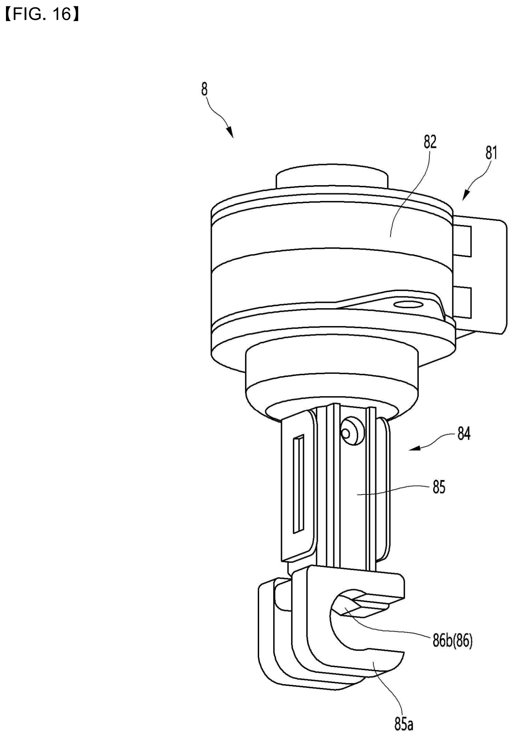

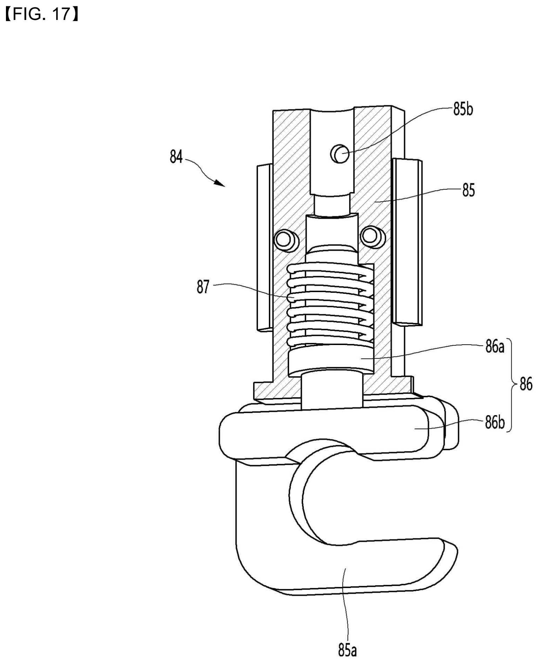

FIG. 14 is a perspective view illustrating a screen module according to the present embodiment, FIG. 15 is an exploded perspective view illustrating a screen module according to the present embodiment, FIG. 16 is an enlarged view illustrating the tilter according to the present embodiment, and FIG. 17 is a partially cut-away perspective view illustrating a moving bracket according to the present embodiment,

The screen module 2 may be provided with a tilting shaft 26. The screen module 2 may be rotatably accommodated in the space S1 of the housing 1.

The screen module 2 can be accommodated in a tiltable manner about a tilting shaft 26 in the space S1 of the housing 1. The screen module 2 can be disposed horizontally or inclined in the space S1 of the housing 1.

The image light can be focused on the screen, and the screen 21 can display an image. The screen 21 can have one end 21a and the other end 21b. The one end 21a of the screen 21 may be the end part of the screen 21 that is closest to the image generation part 3. The other end 21b of the screen 21 may be the end part of the screen 21 that is farthest from the image generation part 3. The space between the one end 21a of the screen 21 and the other end 21b of the screen 21 may be flat.

The screen 21 may include a near area 21c and a far area 21d.

The near area 21c may be a area close to the image generation part 3 among the screens 21. The distance between the near area 21c and the image generation part 3 may be shorter than the distance between the far area 21d and the image generation part 3.

When dividing the screen 21 into two areas based on the center line C2, the near area 21c may be the area between the center line C2 and the end 21a.

The center line C2 of the screen 21 can divide the screen 21 into two parts in the front and rear direction and can be long in the left and right direction.

The upper part of the image displayed through the windshield WS may be displayed in the near area 21c.

The far area 21d may be an area of the screen 21 that is farther from the image generation part 3. The far area 21d may be farther from the image generation part 3 than the inner area 21c.

When dividing the screen 21 into two areas based on the center line C2, the far area 21d may be the area between the center line C2 and the other end 21b.

The lower part of the image displayed through the windshield WS can be displayed in the far area 21d.

A screen 21 can be seated on the screen holder 22. A space in which the screen 21 is accommodated can be formed in the screen holder 22.

The screen cover 23 can hold the screen 21 in the screen holder 22. The screen cover 23 may be formed with a fastening part that is detachably coupled to a protrusion formed in the screen holder 22. The screen holder 22 may be formed with a connector 25 to which the tilter 8 is connected, and a tilting shaft 26 that serves as a tilting center may be formed. The connector 25 may be formed on one side of the screen holder 22, and the tilting shaft 26 may be formed on the other side of the screen holder 22.

The connector 25 may be closer to the near area 21c among the near area 21c and the far area 21d. The connector 25 may be rotatably connected to the tilter 8. The connector 25 may be rotatably connected to the moving bracket 84 of the tilter 8. A hinge axis 25a may be formed in the connector 25.

The tilting shaft 26 may be closer to the far area 21d among the near area 21c and the far area 21d. The tilting shaft 26 may protrude from the screen holder 22. A pair of tilting shaft 26 may be provided on the screen holder 22. The pair of tilting shafts 26 may include a left tilting shaft protruding from the left side of the screen holder 22 and a right tilting shaft protruding from the right side of the screen holder 22.

The screen module 2 may include a spring 27 that elastically supports the tilting shaft 26. The spring 27 may surround the tilting shaft 26. A pair of springs 27 may be provided. The pair of springs 27 may include a left spring that elastically supports the left tilting shaft and a right spring that elastically supports the right tilting shaft.

A shaft supporter 28 that rotatably supports a tilting shaft 26 may be disposed in the housing 1. The shaft supporter 28 may include a bracket 28a and a bearing 28b.

The bracket 28a may be mounted on the housing 1. The bracket 28a may be accommodated in a space S1 of the housing 1. The bracket 28a may be fixed to the housing 1. A space for accommodating a bearing 28b may be formed in the bracket 28a. The bracket 28a may be a bearing housing for accommodating a bearing 28b.

A bearing 28b may be installed in a bracket 28a. The bearing 28b can rotatably support the tilting shaft 26 between the bracket 28a and the tilting shaft 26.

A tilting shaft 26 may be inserted into the bearing 28b, and the bearing 28b may rotatably support the tilting shaft 26.

A pair of shaft supporters 28 may be provided. A pair of shaft supporters 28 may include a left shaft supporter that rotatably supports a left tilting shaft, and a right shaft supporter that rotatably supports a right tilting shaft.

One end 2a of the screen module 2 may be an end part close to the concave mirror 73 of the screen module 2. The other end 2b of the screen module 2 may be an end part far from the concave mirror 73 of the screen module 2.

The screen module 2 may include a near area NA including a connector 25 and a far area FA including a tilting shaft 26.

The near area NA may be an area close to the concave mirror 73 among the screen modules 2. The distance between the near area NA and the concave mirror 73 may be shorter than the distance between the far area FA and the concave mirror 73.

When dividing the screen module 2 into two areas based on the center line, the near area NA may be the area behind the center line and may include one end 2a of the screen module 2.

The far area FA may be an area of the screen 21 that is far from the concave mirror 73.

When the screen module 2 is divided into two areas based on the center line, the far area FA may be the area in front of the center line and may include the other end 2b of the screen module 2.

The distance between the outermost part of the near area NA and the concave mirror 73 may be shorter than the distance between the outermost part of the far area FA and the concave mirror 73.

The head-up display may further include a tilter 8.

The tilter 8 can adjust the angle of the screen module 2. The tilter 8 can adjust the tilting angle of the screen module 2. The tilter 8 may be an angle adjuster that adjusts the angle of the screen module 2. The tilter 8 can tilt the screen module 2 about the tilting shaft 26. The tilter 8 can tilt the screen 21 by tilting the screen module 2 about the tilting shaft 26.

The tilter 8 may include a driving source 81; and a moving bracket 84.

The driving source 81 may include a motor 82 capable of reciprocating the moving bracket 84 in a linear manner. The motor 82 may be provided with a lead screw 83. The lead screw 83 may include a rotating rotor and an elevating rod that is reciprocated in a linear manner by the rotor.

The driving source 81 can raise or lower the moving bracket 84. The driving source 81 can raise the moving bracket 84 to an upper height. The driving source 81 can lower the moving bracket 84 to a lower height.

The driving source 81 can raise and lower the lead screw 83 and the moving bracket 84 within a range of ±10 mm.

The moving bracket 84 can be moved linearly by ± 3 mm.

The driving source 81 can rotate the screen module 2 within a range of ±5°.

The screen module 2 can be tilted up to 5° counterclockwise relative to the horizontal line.

The screen module 2 can be tilted up to 5° clockwise relative to the horizontal line.

The tilting angle range of the screen module 2 may be within 10°.

The screen module 2 can be tilted up to 2° or up to -2° relative to a reference plane. The reference plane can be aligned with a horizontal plane.

When the driving source 81 raises the lead screw 83, the screen module 2 can be tilted counterclockwise around the tilting shaft 26, and the upper surface of the screen 21 can face forward and upward.

When the driving source 81 lowers the lead screw 83, the screen module 2 can be tilted clockwise around the tilting shaft 26, and the upper surface of the screen 21 can face the rear upper side.

The control board 14 (see FIG. 4) can control the motor to raise or lower the moving bracket 84 to a set height after the moving bracket 84 is positioned at a reference height.

When the driving source 81 is driven, the moving bracket 84 can rotate the screen module 2.

The moving bracket 84 is connected to the driving source 81 and can transmit the driving force of the driving source 81 to the screen holder 22.

The moving bracket 84 can be connected to the lead screw of the motor 82. The moving bracket 84 may further include an outer bracket 85 connected to the lead screw 83 of the motor 82; and an inner bracket 86 having a contact end that contacts the connector 25.

A space for accommodating an inner bracket 86 may be formed in the outer bracket 85. A accommodation body 85a for rotatably accommodating a hinge shaft 25a of a connector 25 may be formed in the outer bracket 85.

The accommodation body 85a may be formed at the lower part of the outer bracket 85. The accommodation body 85a may rotatably support the hinge shaft 25a.

The outer bracket 85 may have a fastening part 85b formed to which the lead screw 83 is fastened using a fastening member such as a pin or screw.

The inner bracket 86 may be placed on the outer bracket 85 and can be in contact with the connector 25. The inner bracket 86 may be placed on the outer bracket 85 so as to move in the longitudinal direction of the outer bracket 84.

The inner bracket 86 may include a load 86a and a contact body 86b.

The rod 86a may be placed inside the outer bracket 85.

The contact body 86b may protrude from the bottom of the load 86a and may come into contact with the connector 25. A contact end that comes into contact with the connector 25 may be formed on the lower surface of the contact body 86b.

The moving bracket 84 may further include a spring 87 that is disposed on the outer bracket 85 and elastically supports the inner bracket 86.

The spring 87 can be accommodated in a space formed inside the outer bracket 85 and can elastically support the inner bracket 86. The spring 87 can press the load 86a downward and cause the contact body 86b to be in constant contact with the hinge shaft 25a of the connector 25.

The connector 25 and the moving bracket 84 can be reliably maintained without being arbitrarily removed by the inner bracket 86 and the spring 87.

The control board 14 can control the motor 82 to vary the position of the eye box.

The eye box may be an active area where optical performance is guaranteed. The eye box may be an area where the passenger can reliably recognize the virtual image FI formed by the head-up display. When the passenger's eyes are positioned in the eye box, the passenger can reliably recognize the virtual image formed by the head-up display.

For shorter occupants, a lower position (that is, height) of the eye box is desirable, and for taller occupants, a higher position (that is, height) of the eye box is desirable.

The control board 14 can vary the position of the eye box EB according to the adjustment displacement of the moving bracket 84.

When the moving bracket 84 is raised above the reference height, the height of the virtual image FI in front of the windshield WS can be lowered and the eye box EB can also be lowered.

When the moving bracket 84 is lowered below the reference height, the height of the virtual image FI in front of the windshield WS may be higher and the eye box EB may be higher.

The control board 14 can control the motor 82 in a lowering mode to lower the eye box EB.

The control board 14 can control the motor 82 in a raising mode to raise the eye box EB.

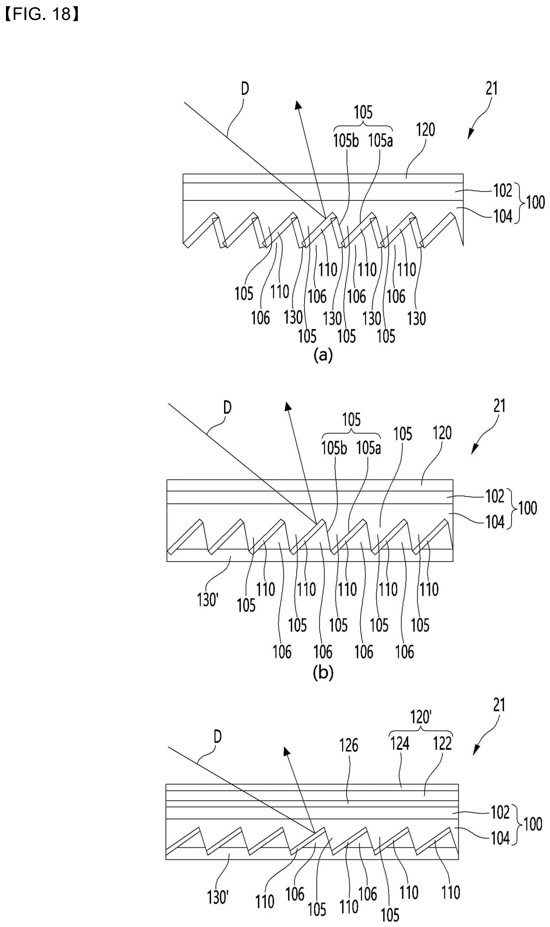

FIG. 18 is a cross-sectional view illustrating a screen according to the present embodiment.

FIG. 18 (a) is a view illustrating a first example of a screen.

A Fresnel pattern may be formed on the screen 21. The Fresnel pattern may be an anisotropic micro-Fresnel pattern.

A first example of a screen 21 may include a Fresnel lens 100, a reflection mirror 110, and a diffuser 120.

A Fresnel lens 100 may be a lens having a function similar to a convex lens, but having a thickness reduced compared to a conventional convex lens, and may be an optical component having continuous concentric grooves formed in plastic.

A Fresnel pattern may be formed on the lower surface of the Fresnel lens 100.

The Fresnel pattern may be formed by sequentially forming a number of concentric grooves of different sizes and may be formed in a shape corresponding to the curvature of the windshield WS.

A Fresnel lens 100 may include a substrate 102 and a Fresnel layer 104 formed on a lower surface of the substrate 102.

The substrate 102 may be made of plastic.

A Fresnel pattern may be formed in the Fresnel layer 104.

On the lower surface of the Fresnel layer 104, mountains 105 and valleys 106 can be formed alternately.

A plurality of concentric grooves forming a Fresnel pattern may be formed by alternately formed mountains 105 and valleys 106.

The mountain 105 may be formed to gradually become smaller in size as it goes downward. The mountain 105 may have an inverted triangle shape.

The mountain 105 may include a first surface 105a and a second surface 105a.

The first surface 105a may be an inclined surface. The second surface 105b may be an inclined surface or a vertical surface.

When both the first surface 105a and the second surface 105b are inclined surfaces, the first surface 105a may be a surface with a gentle slope, and the second surface 105b may be a surface with a steep slope.

The first surface 105a and the second surface 105b can be formed alternately.

The hole 106 can be formed to gradually become smaller in size as it goes upward.

The reflection mirror 110 may be formed on the lower surface of the Fresnel lens 100. The reflection mirror 110 may be formed in a Fresnel pattern. The reflection mirror 110 may be formed on the first surface 105a.

The reflection mirror 110 may be formed by mirror coating. The reflection mirror 110 may be a mirror coating layer formed on the first surface 105a. The reflection mirror 110 may be inclined with respect to a vertical surface.

The diffuser 120 may be formed on the upper surface of the Fresnel lens 100. The diffuser 120 may be formed by a diffusing layer formed on the upper surface of the Fresnel lens 100. The diffusing layer may be formed on the upper surface of the substrate 102. The diffuser 120 may include a diffusing pattern.

The Fresnel lens 100 may further include an absorption layer 130.

The absorption layer 130 may be a layer that absorbs light. The absorption layer 130 may be formed on the second surface 105b.

The absorption layer 130 may be formed alternately with the mirror coating layer.

Image light D can sequentially pass through the diffuser 120 and the Fresnel lens 100 and can be reflected by the reflection mirror 110. The image light D reflected by the reflection mirror 110 can pass through the Fresnel lens 100 and then be focused on the diffuser 120.

FIG. 18 (b) is a view illustrating a second example of a screen.

A second example of the screen may include a Fresnel lens 100, a reflection mirror 110 and a diffuser 120, as illustrated in FIG. 18 (b) and may further include an absorption layer 130' that absorbs light.

The Fresnel lens 100 may be identical or similar to the Fresnel lens 100 of the first example of the screen, and to avoid duplicate description, the same symbol is used and a description thereof is omitted.

The reflection mirror 110 may be identical or similar to the reflection mirror 110 of the first example of the screen, and to avoid duplicate description, the same symbol is used and a description thereof is omitted.

The diffuser 120 may be identical or similar to the diffuser 120 of the first example of the screen, and to avoid duplicate description, the same symbol is used and the description thereof is omitted.

The absorption layer 130' may be formed on the lower surface of the Fresnel lens 100. The absorption layer 130' may be formed on the lower surface of the Fresnel lens 100. The absorption layer 130' may be in contact with the lower ends of the plurality of mountains 105. The absorption layer 130' may be in contact with each of the lower ends of the plurality of mountains 105 and may have a shape connecting the lower ends of the plurality of mountains 105.

The absorption layer 130' can shield the mountain 105 and the valley 106. The absorption layer 130' can be formed parallel to the diffuser 120.

A void may be formed between the absorption layer 130' and the Fresnel lens 100.

FIG. 18 (c) is a view illustrating a third example of a screen.

A third example of a screen may include, as illustrated in FIG. 18 (c), a Fresnel lens 100 having a Fresnel pattern formed on a lower surface; a reflection mirror 100 formed on the Fresnel pattern; a diffuser 120 formed on an upper surface of the Fresnel lens 100; and an absorption layer 130' that absorbs light.

The Fresnel lens 100 may include a substrate 102; and a Fresnel layer 104 formed on the lower surface of the substrate 102 and having a Fresnel pattern formed thereon, and may be identical or similar to the Fresnel lens 100 of the first example of the screen, and to avoid duplicate description, the same reference numerals are used and a description thereof is omitted.

The reflection mirror 110 may be identical or similar to the reflection mirror 110 of the first example of the screen, and to avoid duplicate description, the same symbol is used and a description thereof is omitted.

The diffuser 120' may include a diffuser substrate 122 and a diffuser layer 124.

The diffuser substrate 122 may be bonded to the upper surface of the substrate 102 with an adhesive 126.

A diffuser layer 124 may be formed on the upper surface of the diffuser substrate 122.

The absorption layer 130' may be identical to or similar to the absorption layer 130 of the first example of the screen or the absorption layer 130' of the second example of the screen, and to avoid duplicate description, the same symbol as the absorption layer 130' of the second example of the screen is used and a description thereof is omitted.

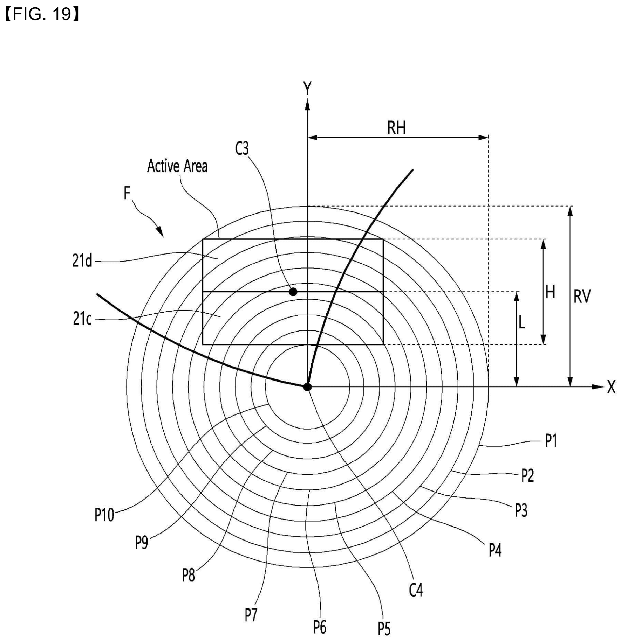

FIG. 19 is a rear view illustrating a screen according to the present embodiment.

The center C3 of the screen 21 may be offset from the center C4 of the Fresnel pattern F.

The center C3 of the screen 21 may be the center of the active area where the image light D is focused on the screen 21. The frame of the screen 21 may be covered by a screen cover 23, and the image light D may be focused on the inner area of the frame of the screen 21, and the image light D may not be focused on the frame of the screen 21.

The screen 21 may include an active area where image light D is focused and an inactive area where image light D is not focused.

The active area may be an area of the screen 21 that is not covered by the screen cover 23. The active area may be an area visible through the opening 23a of the screen cover 23.

The inactive area may be an area of the screen 21 covered by the screen cover 23.

The center C4 of the Fresnel pattern F may be the center of the concentric circles P1, P2, P3, P4, P5, P6, P7, P8, P9, P10 that constitute the Fresnel pattern F.

The Fresnel pattern F may have different radii in the horizontal axis (X-axis) and the vertical axis (Y-axis). The horizontal axis (X-axis) may be long in the left and right direction, and the vertical axis (Y-axis) may be long in the front and rear direction.

Each of the concentric circles P1, P2, P3, P4, P5, P6, P7, P8, P9, P10 may have a radius RH in the horizontal axis (X-axis) that may be different from the radius RV along the vertical axis (Y-axis). The radius RH in the horizontal axis (X-axis) may be greater than the radius Rv along the vertical axis (Y-axis).

The separation distance L between the center C3 of the active area and the horizontal axis (X-axis) of the Fresnel pattern F may be greater than half H/2 of the vertical length H of the active area.

When the separation distance L is half H/2 of the vertical length H of the active area, the offset can be defined as 100%, and the separation distance L can be greater than half H/2 of the vertical length H of the active area so that the offset can exceed 100%.

The center C3 of the active area can be offset from the vertical axis (Y-axis) of the Fresnel pattern F.

The windshield WS can have curvature in the vertical direction and the left and right direction.

The Fresnel pattern F of the screen 21 may be formed corresponding to the curvature of the windshield WS. The curvature of the Fresnel pattern F may have an opposite tendency to the curvature of the windshield WS. The curvature of the Fresnel pattern F can be inversely proportional to the curvature of the windshield WS.

As the horizontal curvature of the windshield WS increases, the horizontal curvature of the Fresnel pattern F can decrease. In other words, the ratio (RH/RV) of the radius RH in the horizontal axis (X-axis) to the radius RV in the vertical axis (Y-axis) can increase. As the horizontal curvature of the windshield WS increases, the radius RH in the horizontal axis (X-axis) of the Fresnel pattern F can increase.

Conversely, as the horizontal curvature of the windshield WS decreases, the horizontal curvature of the Fresnel pattern F increases. In other words, the ratio (RH/RV) of the radius RH in the horizontal axis (X-axis) to the radius RV in the vertical axis (Y-axis) can decrease. As the horizontal curvature of the windshield WS decreases, the radius RH along the horizontal axis (X-axis) of the Fresnel pattern F can decrease.

As the vertical curvature of the windshield WS increases, the vertical curvature of the Fresnel pattern F can decrease. In other words, the ratio (RH/RV) of the radius of the horizontal axis (X-axis) to the radius of the vertical axis (Y-axis) can decrease. As the vertical curvature of the windshield WS increases, the radius of the vertical axis (Y-axis) RV can increase.

Conversely, as the vertical curvature of the windshield WS decreases, the vertical curvature of the Fresnel pattern F can increase. In other words, the ratio (RH/RV) of the radius (RH) in the horizontal axis (X-axis) and the radius (RV) in the vertical axis (Y-axis) can increase. As the vertical curvature of the windshield WS decreases, the radius along the vertical axis (Y-axis) RV can decrease.

When the head-up display is a left head-up display positioned on the left part of the dashboard, the center C3 of the active area of the screen 21 may be offset to the right with respect to the center C4 of the Fresnel pattern F. In this case, the center C3 of the active area may be located to the right of the vertical axis (Y-axis) of the Fresnel pattern F.

In other words, the center C of the active area of the screen 21 included in the left head-up display can be offset to the right with respect to the center C4 of the Fresnel pattern F.

Conversely, the Fresnel pattern F of the screen 21 included in the left head-up display may be offset to the left based on the center C3 of the active area of the screen 21.

When the head-up display may be a right head-up display positioned on the right part of the dashboard, the center C3 of the active area of the screen 21 may be offset to the left with respect to the center C4 of the Fresnel pattern F. In this case, the center C3 of the active area may be located to the left of the vertical axis (Y-axis) of the Fresnel pattern F.

In other words, the center C3 of the active area of the screen 21 included in the right head-up display can be offset to the left with respect to the center C4 of the Fresnel pattern F.

Conversely, the Fresnel pattern F of the screen 21 included in the right head-up display may be offset to the right based on the center C3 of the active area of the screen 21.

As the horizontal curvature of the windshield WS increases, the offset size (that is, the offset amount) can increase. As the horizontal curvature of the windshield WS increases, the offset of the center C3 of the active area of the screen 21 from the vertical axis (Y-axis) can increase.

The near area 21c of the screen 21 may be spaced apart from the horizontal axis (X-axis) of the Fresnel pattern F. The near area 21c of the screen 21 may be spaced apart from the horizontal axis (X-axis) of the Fresnel pattern F in the front and rear direction.

The center of the active area C3 may be offset from the vertical axis (Y-axis) of the Fresnel pattern F.

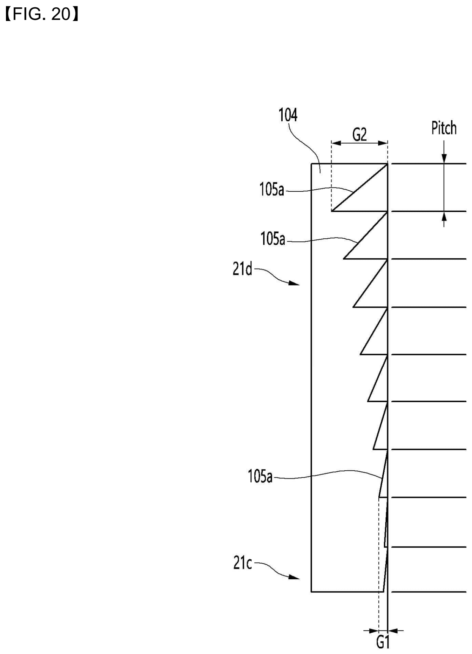

FIG. 20 is a cross-sectional view illustrating the Fresnel layer of the screen according to the present embodiment.

The pitch of the Fresnel pattern F may be in the range of 50 µm to 150 µm.

The angle of the first surface 105a of the Fresnel pattern F may gradually increase from the near area 21c to the far area 21d. The angle of the first surface 105a of the far area 21d may be greater than the angle of the first surface 105a of the near area 21c.

The pitch of the Fresnel pattern F may be the same, and the valley depth G1 of the near area 21c may be different from the valley depth G2 of the far area 21d. When the pitch of the Fresnel pattern F is the same, the valley depth G2 of the far area 21d may be greater than the valley depth G1 of the near area 21c. When the pitch of the Fresnel pattern F is the same, the valley depth of the Fresnel pattern F may gradually become deeper as it goes from the near area 21c to the far area 21d.

The valley depths of the Fresnel pattern F are the same, and the pitch of the near area 21c may be different from the pitch of the far area 21d. When the valley depths of the Fresnel pattern F are the same, the pitch of the far area 21d may be smaller than the pitch of the near area 21c. When the valley depths of the Fresnel pattern F are the same, the pitch of the Fresnel pattern F may gradually become smaller as it goes from the near area 21c to the far area 21d.

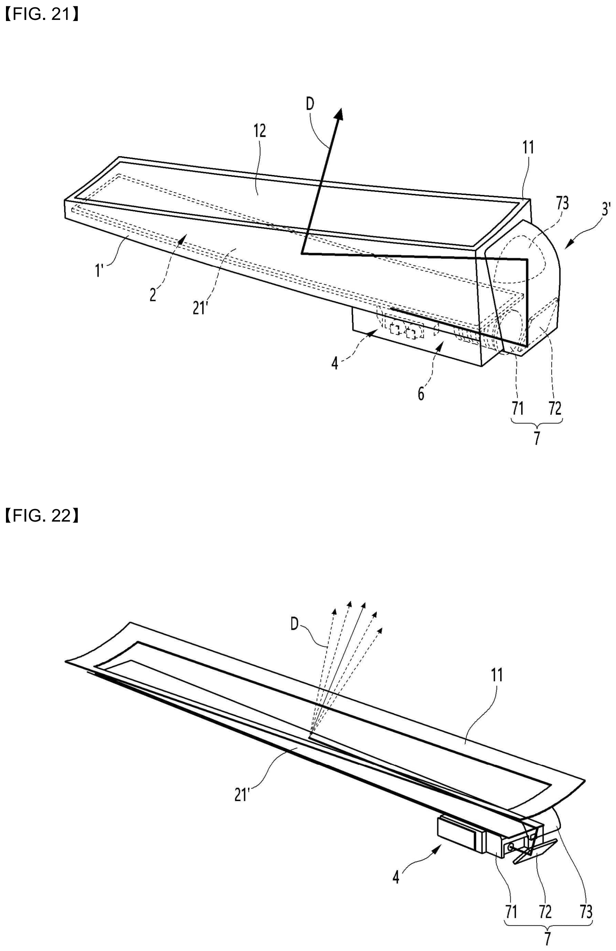

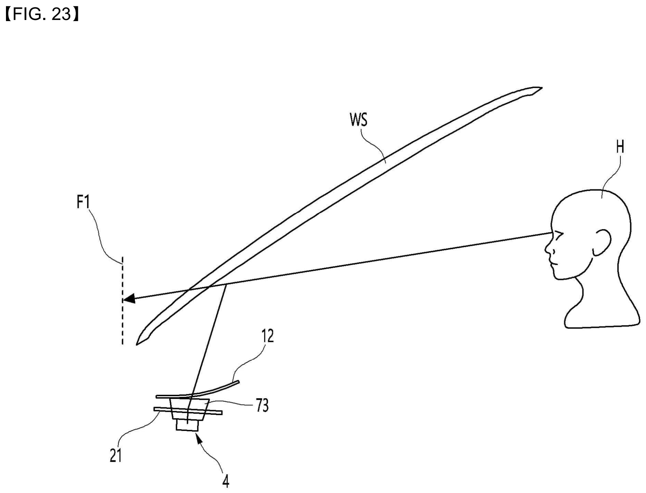

FIG. 21 is a perspective view illustrating a modified example of a head-up display according to the present embodiment, FIG. 22 is a perspective view illustrating the interior of a modified example of a head-up display according to the present embodiment, and FIG. 23 is a schematic diagram illustrating a modified example of a head-up display according to the present embodiment.

Another example of a head-up display may include a housing 1', a screen module 2 accommodated in the housing 1', a top cover 11 disposed on an upper side of the housing 1', a dust cover 12 disposed on the top cover 11, and an image generation part 3 disposed on at least one surface of the housing 1' or the top cover 11.

The length of the housing 1' in the left and right direction may be longer than the length of the housing 1 in the left and right direction included in an example of a head-up display.

The screen module 2 may include a screen 21'.

The screen 21' can focus image light D and reflect the image light D onto the windshield.

The screen 21' may have an anisotropic micro-Fresnel pattern with directionality and may have a diffusing pattern.

The screen module 2 may be identical or similar to the screen module 2 of the head-up display, and to avoid duplicate description, the same symbol is used and a detailed description thereof is omitted.

The length of the screen module 2 in the left and right direction may be longer than the screen module 2 in the left and right direction included in an example of a head-up display.

The image generation part 3 may have an overall 'L' shape.

The image generation part 3 may be a side image generation part which is disposed on one surface of the housing 1' or one surface of the top cover 11 and on the lower side of the housing 1', and may project image light D toward the screen 21' of the screen module 2.

The image generation part 3 may include an illumination optical module 4 that generates and irradiates light; an image generator 6 that receives the light irradiated from the illumination optical module 4 and generates image light D; and a projection optical module 7' that projects the image light D generated from the image generator 6 onto the screen module 2.

The illumination optical module 4 and the image generator 6 may be placed on the lower side of the housing 1'.

The illumination optical module 4 may be identical or similar to the illumination optical module 4 of the head-up display, and to avoid duplicate description, the same symbol is used and a detailed description thereof is omitted.

The image generator 6 may be identical or similar to the image generator 6 of the head-up display, and to avoid duplicate description, the same symbol is used and a detailed description thereof is omitted.

The projection optical module 7' may include at least one projection lens 71; a projection conversion mirror (Folding Mirror) 72 that reflects image light transmitted through the projection lens 71 upward; and a concave mirror 73 that expands image light reflected from the projection conversion mirror 72 to the screen module 2.

The projection optical module 7' may have an overall 'L' shape.

The projection lens 71 may be placed on the lower side of the housing 1'.

The projection conversion mirror 72 may be placed next to the projection lens 71. The projection conversion mirror 72 may be spaced apart from the projection lens 71 in the left and right direction.

The concave mirror 73 may be placed above the projection conversion mirror 72. The concave mirror 73 may be placed next to the housing 1' or the top cover 11 and may project image light D onto the screen 21'.

The head-up display can be configured as an extreme wide hover screen (EWHS).

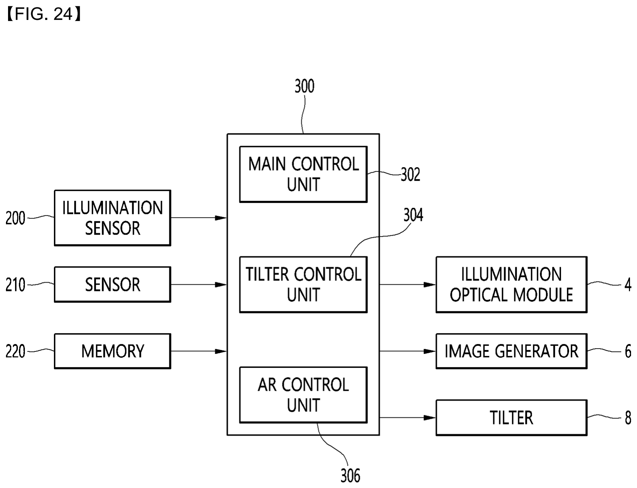

FIG. 24 is a control block diagram of a head-up display according to the present embodiment.

The head-up display may further include a illumination sensor 200 that senses the illumination of the vehicle interior. The illumination sensor 200 may be an external illumination sensor positioned outside the head-up display. The illumination sensor 200 may be installed on a dashboard or the like. The illumination sensor 200 may be connected to a control board 14 by a signal line. The illumination sensor 200 may detect illumination and transmit a signal according to the sensed value to the control board 14.

The control board 14 can vary at least one of the brightness and color of the image generation part 3 or 3' when a signal is received from the illumination sensor 200. The image generation part 3 or 3' can control a plurality of light sources 41, 42, and 43.

The control board 14 can receive driver information and control the motor 82 of the tilter 8 according to the received information.

The head-up display may include a sensor 210 that senses the driver's eyes. The sensor 210 may be an optical sensor. An example of the sensor 210 may be a camera sensor.

Driver information can be acquired by a sensor 210, the sensor 210 can transmit a sensing value to a control board 14, and the control board 14 can receive driver information when a signal is received from the sensor 210.

The control board 14 can control the motor 82 to an raising mode when the driver's eye height received from the sensor 210 is lower than the reference eye height, and the moving bracket 84 may be raised.

The control board 14 can control the motor 82 to a lowering mode when the driver's eye height received from the sensor 210 is higher than the reference eye height, and the moving bracket 84 may be lowered.

The head-up display may further include a memory 220 in which the mode immediately before power-off is stored when the display is powered off. The memory 220 may be provided on the control board 14.

After the power is turned off, when the power is turned on again, the control board 14 can compare the mode stored in the memory 220 with the mode according to the driver information and control the motor 82 of the tilter 8 according to the comparison result.

The control board 14 may include a control unit 300.

The control unit 300 may further include a main control unit 302 that controls the image generation part 3.

The main control unit 302 can control a plurality of light sources 41, 42, and 43 and an image generator 6.

The main control unit 302 can vary at least one of the brightness and color of the image generation part 3 according to the sensing value of the illumination sensor 200.

The main control unit 302 can control a plurality of light sources 41, 42, and 43 according to the sensing value of the illumination sensor 200.

The control unit 300 may further include a tilter control unit 304 that controls the tilter 8.

The tilter control unit 304 can control the motor 82 of the tilter 8.

The control unit 300 may further include an AR control unit (Augmented Reality Control unit) 306 that adds virtual graphics to the image. The AR control unit 306 can transmit a signal to the main control unit 302, and the main control unit 302 can control a plurality of light sources 41, 42, and 43 and an image generator 6 to add virtual graphics to the image.

The above description is merely an illustrative explanation of the technical idea of the present disclosure, and various modifications and variations will be possible to those skilled in the art without departing from the essential characteristics of the present disclosure.

Accordingly, the embodiments disclosed in the present disclosure are not intended to limit the technical idea of the present disclosure, but are for illustrative purposes, and the scope of the technical idea of the present disclosure is not limited by these embodiments.

The scope of protection of the present disclosure should be interpreted in accordance with the claims below, and all technical ideas within the equivalent scope should be interpreted as being comprised in the scope of rights of the present disclosure.

## Claims

1. A head-up display comprising:
a housing having a space formed in the housing;
a screen module having a tilting shaft and rotatably accommodated in the space;
an image generating part that generates image light from outside the space and projects the image light onto the screen module; and
a tilter that adjusts a tilting angle of the screen module,
wherein the screen module is provided with a connector rotatably connected to the tilter.

2. The head-up display of claim 1,
wherein the screen module comprises
a far region comprising the tilting shaft; and
a near region comprising the connector.

3. The head-up display of claim 2,
wherein the image generating part comprises:
a concave mirror that expands image light onto the screen module,
wherein a distance between an outermost edge of the near region and the concave mirror is shorter than a distance between an outermost edge of the far region and the concave mirror.

4. The head-up display of claim 1,
wherein the screen module further comprises:
a screen; and
a screen holder that accommodates the screen, and has the connector formed on one end of the screen holder and the tilting shaft formed on the other end of the screen holder.

5. The head-up display of claim 4,
wherein the screen module further comprises:
a screen cover that holds the screen on the screen holder.

6. The head-up display of claim 1, further comprising
a bracket fixed to the housing; and
a spring disposed between the bracket and the tilting shaft.

7. The head-up display of claim 1,
wherein the housing is made of metal.

8. The head-up display of claim 1,
wherein the tilter comprises:
a motor; and
a moving bracket connected to the motor and linearly moved, and
wherein the connector is rotatably connected to the moving bracket.

9. The head-up display of claim 8, further comprising;
a control board that controls the motor to vary a position of the eye box.

10. The head-up display of claim 8,
wherein the position of the eye box varies according to an adjustment displacement of the moving bracket.

11. The head-up display according to claim 8,
wherein when the moving bracket is raised above a reference height, the eye box is lowered, and
when the moving bracket is lowered below the reference height, the eye box is raised.

12. The head-up display according to claim 8,
wherein the moving bracket comprises:
an outer bracket connected to a lead screw of the motor;
an inner bracket disposed to move along a longitudinal direction of the outer bracket and having a contact end in contact with the connector; and
a spring disposed in the outer bracket to elastically support the inner bracket.

13. The head-up display according to claim 8,
wherein the moving bracket is linearly moved by ±3 mm.

14. The head-up display according to claim 8, wherein a tilting angle range of the screen module is within 10°.

15. The head-up display of claim 8,
wherein the screen module tilts at maximum 2° or at maximum -2° relative to a reference plane.

16. The head-up display of claim 8, further comprising;
a control board that controls the motor to raise or lower the moving bracket to a set height after the moving bracket is positioned at a reference height.

17. The head-up display of claim 8, further comprising
a control board that receives driver information and controls the motor based on the information.

18. The head-up display of claim 17, further comprising a sensor that senses the driver's eyes.

19. The head-up display according to claim 17, further comprising:
a memory is provided for storing a mode immediately prior to power-off, when power is turned off;
after power is turned off, when power is reapplied, the control board compares the mode stored in the memory with a mode based on the driver information and controls the motor based on a comparison result.
